# EUROPEAN PATENT SPECIFICATION

(11) **EP 4 392 970 B1**
(45) Date of publication and mention of the grant of the patent: **10.12.2025**
(21) Application number: 22769496.5
(22) Date of filing: 24.08.2022
(51) Int. Cl.: G10L 19/16, H03G 7/00, G10L 21/0364, H03G 3/00, H03G 11/00

(54) **METHOD AND APPARATUS FOR METADATA-BASED DYNAMIC PROCESSING OF AUDIO DATA**
VERFAHREN UND VORRICHTUNG ZUR METADATENBASIERTEN DYNAMISCHEN VERARBEITUNG VON AUDIODATEN
PROCÉDÉ ET APPAREIL DE TRAITEMENT DYNAMIQUE DE DONNÉES AUDIO DYNAMIQUE BASÉS SUR DES MÉTADONNÉES

(30) Priority: 26.08.2021 EP 21193209; 26.08.2021 US 202163237231 P; 01.10.2021 US 202163251307 P
(43) Date of publication of application: 03.07.2024
(73) Proprietor: Dolby Laboratories Licensing Corporation, San Francisco, CA 94103 (US); Dolby International AB, Dublin, D02 VK60 (IE)
(72) Inventor: FERSCH, Christof, San Francisco, California 94103 (US); NORCROSS, Scott Gregory, San Francisco, California 94103 (US)
(74) Representative: Dolby International AB Patent Group Europe
(86) International application number: PCT/US2022/041388
(87) International publication number: WO 2023/028154

(56) References cited:
- WO-A1-2020/185025
- US-A1- 2016 219 387
- US-A1- 2018 091 917
- US-A1- 2018 095 718
- JEFFREY RIEDMILLER ET AL: "Delivering Scalable Audio Experiences using AC-4", IEEE TRANSACTIONS ON BROADCASTING., vol. 63, no. 1, 24 February 2017 (2017-02-24), US, pages 179 - 201, XP055611935, ISSN: 0018-9316, DOI: 10.1109/TBC.2017.2659623
- "Text of ISO/IEC 23003-4, Dynamic Range Control, 2nd Edition", no. n17643, 5 June 2018 (2018-06-05), XP030262172, Retrieved from the Internet <URL:http://phenix.int-evry.fr/mpeg/doc_end_user/documents/122_San%20Diego/wg11/w17643-v2-w17643.zip> [retrieved on 20180605]

## Description

### CROSS REFERENCE TO RELATED APPLICATIONS

This application claims priority to European Patent Application No. 21193209.0, filed 26 August 2021 and US provisional application 63/237,231, filed 26 August 2021, and 63/251,307, filed 01 October 2021.

### TECHNOLOGY

The present disclosure relates generally to a method of metadata-based dynamic processing of audio data for playback and, in particular, to determining and applying one or more processing parameters to the audio data for dynamic loudness adjustment and/or dynamic range compression. The present disclosure further relates to a method of encoding audio data and metadata for dynamic loudness adjustment and/or dynamic range compression into a bitstream. The present disclosure yet further relates to a respective decoder and encoder as well as to a respective system and computer program products.

While some embodiments will be described herein with particular reference to that disclosure, it will be appreciated that the present disclosure is not limited to such a field of use and is applicable in broader contexts.

### BACKGROUND

Any discussion of the background art throughout the disclosure should in no way be considered as an admission that such art is widely known or forms part of common general knowledge in the field.

**In** playing back audio content, loudness is the individual experience of sound pressure. In cinematic or television content, the loudness of dialogue in a program has been found to be the most crucial parameter determining the perception of program loudness by a listener.

To determine the average loudness of a program, either of the full program or dialogue only, analysis of the entire program has to be performed. The average loudness is typically required for loudness compliance (for example, the CALM act in the US), and is also used for aligning dynamic range control (DRC) parameters. The dynamic range of a program is the difference between its quietest and loudest sounds. The dynamic range of a program depends on its content, for example, an action movie may have a different and wider dynamic range than a documentary, and reflects a creator's intent. However, capabilities of devices to play back audio content in the original dynamic range vary strongly. Besides loudness management, dynamic range control is thus a further key factor in providing optimal listening experience.

To perform loudness management and dynamic range control, the entire audio program or an audio program segment has to be analyzed and the resulting loudness and DRC parameters can be delivered along with audio data or encoded audio data to be applied in a decoder or playback device.

When analysis of an entire audio program or an audio program segment prior to encoding is not available, for example in real-time (dynamic) encoding, loudness processing or levelling is used to ensure loudness compliance and, if applicable, potential dynamic range constraints depending on playback requirements. This approach delivers processed audio that is "optimized" for a single playback environment.

There is thus an existing need for metadata-based processes that deliver "original" unprocessed audio with accompanying metadata allowing the playback device to use the metadata to modify the audio dynamically depending on device constraints or user requirements.

US2016/219387A1 describes that audio content coded for a reference speaker configuration is downmixed to downmix audio content coded for a specific speaker configuration. One or more gain adjustments are performed on individual portions of the downmix audio content coded for the specific speaker configuration. Loudness measurements are then performed on the individual portions of the downmix audio content. An audio signal that comprises the audio content coded for the reference speaker configuration and downmix loudness metadata is generated. The downmix loudness metadata is created based at least in part on the loudness measurements on the individual portions of the downmix audio content.

JEFFREY RIEDMILLER ET AL: "Delivering Scalable Audio Experiences using AC-4", IEEE TRANSACTIONS ON BROADCASTING., Vol. 63, No. 1, 24 February 2017, discusses scalable audio experiences using AC-4.

"Text of ISO/IEC 23003-4, Dynamic Range Control, 2nd Edition", 122. MPEG MEETING; 20180416 - 20180420; SAN DIEGO; (MOTION PICTURE EXPERT GROUP OR ISO/IEC JTC1/SC29/WG11), no.n17643, 5 June 2018, discusses Dynamic Range Control (DRC) and how to provides efficient control of dynamic range, loudness, and clipping based on metadata generated at an encoder.

WO2020185025A1 describes an audio signal processing device which comprises: a receiving unit for receiving an input audio signal; a processor for generating loudness metadata corresponding to the input audio signal; and an output unit for transmitting the loudness metadata generated by the processor. The processor acquires loudness information analyzed from input content, acquires loudness information about the input audio signal by measuring the loudness of the input audio signal, generates the loudness metadata by converting the loudness information, and transmits, through the output unit, the generated loudness metadata to an output device for outputting the input audio signal.

US2018/091917A1 describes an audio signal processing device for processing an audio signal. The audio signal processing device includes a receiving unit configured to receive the audio signal; a processor configured to determine whether to render the audio signal by reflecting a location of a sound image simulated by the audio signal on the basis of metadata for the audio signal, and render the audio signal according to a result of the determination; and an output unit configured to output the rendered audio signal.

US2018/095718A1 is directed to a method and system for receiving, in a bitstream, metadata associated with the audio data, and analyzing the metadata to determine whether a loudness parameter for a first group of audio playback devices are available in the bitstream. Responsive to determining that the parameters are present for the first group, the system uses the parameters and audio data to render audio. Responsive to determining that the loudness parameters are not present for the first group, the system analyzes one or more characteristics of the first group, and determines the parameter based on the one or more characteristics.

### SUMMARY

In accordance with a first aspect of the present disclosure there is provided a method of metadata-based dynamic processing of audio data for playback according to claim 1.

In accordance with a second aspect of the present disclosure there is provided a decoder for metadata-based dynamic processing of audio data for playback according to claim 3.

In accordance with a third aspect of the present disclosure there is provided a method of encoding audio data and metadata for dynamic loudness adjustment, into a bitstream according to claim 4.

In accordance with a fourth aspect of the present disclosure there is provided an encoder for encoding in a bitstream original audio data and metadata for dynamic loudness adjustment according to claim 11.

In accordance with a fifth aspect of the present disclosure there is provided a system of an encoder for encoding in a bitstream original audio data and metadata for dynamic loudness adjustment, and a decoder for metadata-based dynamic processing of audio data for playback according to claim 12.

In accordance with a sixth aspect of the present disclosure there is provided a computer program product according to claim 13.

In accordance with a seventh aspect of the present disclosure there is provided a computer-readable storage medium according to claim 14.

Preferred embodiments are defined by the dependent claims.

### BRIEF DESCRIPTION OF THE DRAWINGS

Example embodiments of the disclosure will now be described, by way of example only, with reference to the accompanying drawings in which:
FIG. 1 illustrates an example of a decoder for metadata-based dynamic processing of audio data for playback.
FIG. 2 illustrates an example of a method of metadata-based dynamic processing of audio data for playback.
FIG. 3 illustrates an example of an encoder for encoding in a bitstream original audio data and metadata for dynamic loudness adjustment.
FIG.4 illustrates an example of a method of encoding audio data and metadata for dynamic loudness adjustment, into a bitstream.
FIG. 5 illustrates an example of a device comprising one or more processors and non-transitory memory configured to perform the methods described herein.

### DESCRIPTION OF EXAMPLE EMBODIMENTS

### Overview

The average loudness of a program or dialogue is the main parameter or value used for loudness compliance of broadcast or streaming programs. The average loudness is typically set to -24 or - 23 LKFS. With audio codecs that support loudness metadata, this single loudness value representing the loudness of the entire program, is carried in the bitstream. Using this value in the decoding process allows gain adjustments that result in predictable playback levels, so that programs play back at known consistent levels. Therefore, it is important that this loudness value is set properly and accurately. Since the average loudness is dependent on measuring the entire program prior to encoding, for real-time situations such as dynamic encoding with unknown loudness and dynamic range variation, this is, however, not possible.

When it is not possible to measure the loudness of the entire file prior to encoding, a dynamic loudness leveler is often used to modify or contour the audio data prior to encoding so that it meets the required loudness. This type of loudness management is often seen as an inferior method to meet compliance, as it often changes the dynamic range intercorrelation in the audio content and may thus change the creative intent. This is especially the case when it is desired to distribute one audio asset for all playback devices, which is one of the benefits of metadata driven codec and delivering systems.

In some approaches, audio content is mixed with the required target loudness, and the corresponding loudness metadata is set to that value. A loudness leveler might still be used in those situations as it will be used to help steer the audio content to the target loudness but it will not be that "active" and is only used to when the audio content starts to deviate from the required target loudness.

In view of the above, methods and apparatus described herein aim at making real-time processing situations, also denoted as dynamic processing situations, also metadata driven. The metadata allow for dynamic loudness adjustment and dynamic range compression in real-time situations. The methods and apparatus as described advantageously enable:
- Use of real-time loudness adjustment and DRC in MPEG-D DRC syntax;
- Use of real-time loudness adjustment and DRC in combination with downmixId;
- Use of real-time loudness adjustment and DRC in combination with drcSetId;
- Use of real-time loudness adjustment and DRC in combination with eqSetId.

That is, depending on decoder settings (e.g., DRCSet, EQSet, and downmix), a decoder can search based on the syntax a given payload for an appropriate set of parameters and identifiers, by matching the aforementioned settings to the identifiers. The parameters included in the set whose identifiers best match the settings can then be selected as the processing parameters for dynamic loudness adjustment to be applied to received original audio data for correction.

Further, multiple sets of parameters for dynamic processing (multiple instances of dynLoudCompValue) can be transmitted.

The metadata-driven dynamic loudness compensation, in addition to correcting the overall loudness, can also be used to "center" the DRC gain calculation and application. This centering may be a result of correcting the loudness of the content, via the dynamic loudness compensation, and how DRC is typically calculated and applied. In this sense, metadata for dynamic loudness compensation can be said to be used for aligning DRC parameters.

### Metadata-based dynamic processing of audio data

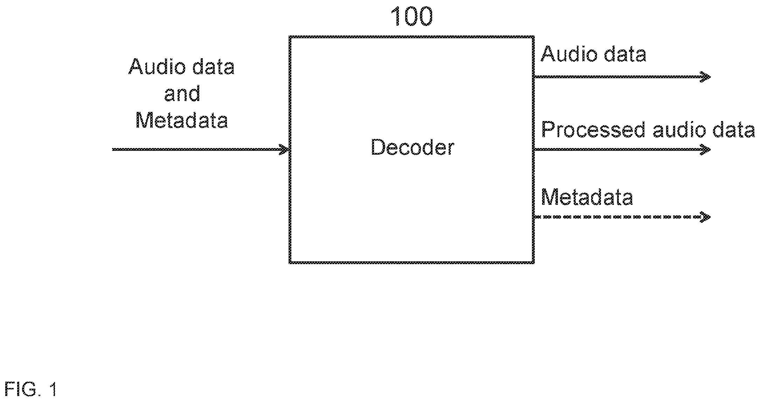

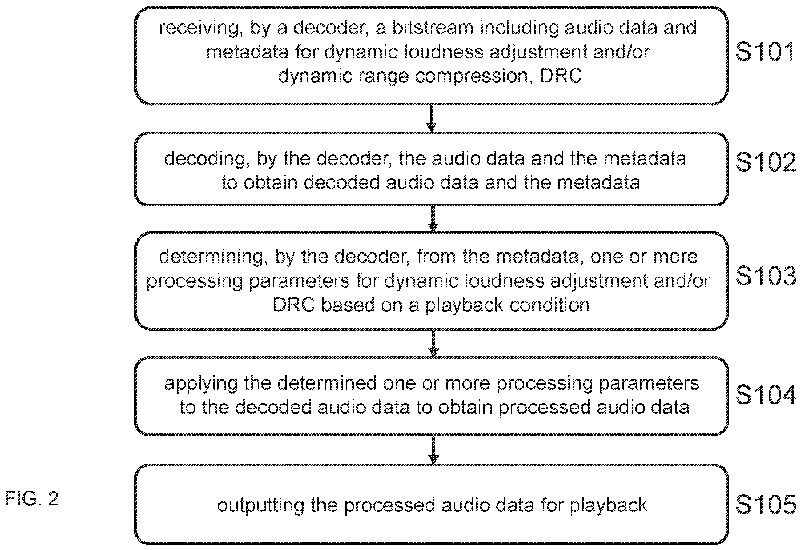

Referring to the example of Figure 1, a decoder 100 for metadata-based dynamic processing of audio data for playback is described. The decoder 100 may comprise one or more processors and non-transitory memory configured to perform a method including the processes as illustrated in the example of Figure 2 by means of steps S101 to S105.

The decoder 100, may receive a bitstream including audio data and metadata and may be able to output the unprocessed (original) audio data, the processed audio data after application of dynamic processing parameters determined from the metadata and/or the metadata itself depending on requirements.

Referring to the example of Figure 2, in step S101 the decoder 100 may receive a bitstream including audio data and metadata for dynamic loudness adjustment and optionally, dynamic range compression (DRC). The audio data may be encoded audio data, the audio data may further be unprocessed. That is, the audio data may be said to be original audio data. The metadata may include a plurality of sets of metadata. For example, each payload of metadata may include such plurality of sets of metadata. These different sets of metadata may relate to respective playback conditions (e.g., to different playback conditions).

According to the invention, the bitstream is an MPEG-D DRC bitstream. The presence of metadata for dynamic processing of audio data is then signaled based on MPEG-D DRC bitstream syntax. In an embodiment, a loudnessInfoSetExtension()-element may be used to carry the metadata as a payload as detailed further below.

In step S102, the audio data and the metadata may then be decoded, by the decoder, to obtain decoded audio data and the metadata. In an embodiment, the metadata may include one or more processing parameters relating to average loudness values and optionally one or more processing parameters relating to dynamic range compression characteristics. It is understood that each set of metadata may include respective processing parameters.

The metadata allows to apply dynamic or real-time correction. For example, when encoding and decoding for live real-time playout, the application of the "real-time" or dynamic loudness metadata is desired to ensure that the live playout audio is properly loudness managed.

In step S103, the decoder then determines, from the metadata, one or more processing parameters for dynamic loudness adjustment based on a playback condition. This may be done by using the playback condition or information derived from the playback condition (e.g., playback condition information), to identify an appropriate set of metadata among the plurality of sets of metadata.

In an embodiment, a playback condition may include one or more of a device type of the decoder, characteristics of a playback device, characteristics of a loudspeaker, a loudspeaker setup, characteristics of background noise, characteristics of ambient noise and characteristics of the acoustic environment. Preferably, the playback condition information may be indicative of a specific loudspeaker setup. The consideration of a playback condition allows the decoder for a targeted selection of processing parameters for dynamic loudness adjustment with regard to device and environmental constraints.

In an embodiment, the process of determining the one or more processing parameters in step S103 includes selecting, by the decoder, a set of DRC sequences, DRCSet, and may further include selecting a set of equalizer parameters, EQSet, and a downmix, corresponding to the playback condition. Thus, the at least one of a DRCSet, EQSet and downmix correlates with or is indicative of the individual device and environmental constraints due to the playback condition.

Step S103 involves selecting a set of DRC sequences, DRCSet. In other words, the selected set of metadata includes such set of DRC sequences.

In an embodiment, the process of determining in step S103 may further include identifying a metadata identifier indicative of the at least one selected DRCSet, EQSet and DownmixSet to determine the one or more processing parameters from the metadata. The metadata identifier thus enables to connect the metadata with a corresponding selected DRCSet, EQSet, and/or downmix, and thus with a respective playback condition.

In an embodiment, the specific loudspeaker setup may be used to determine a downmix, which in turn may be used for identifying and selecting an appropriate one among the plurality of sets of metadata. In such case, the specific loudspeaker setup and/or the downmix may be indicated by the aforementioned playback condition information.

In an embodiment, the metadata may comprise one or more metadata payloads (e.g., dynLoudComp() payloads, such as shown in ***Table 5*** below), wherein each metadata payload may include a plurality of sets of parameters (e.g., parameters dynLoudCompValue) and identifiers, with each set including at least one of a DRCSet identifier, drcSetId, an EQSet identifier, eqSetId, and a downmix identifier, downmixId, in combination with one or more processing parameters relating to the identifiers in the set. That is, each payload may comprise an array of entries, each entry including processing parameters and identifiers (e.g., drcSetId, eqSetId, downmixId). The array of entries may correspond to the plurality of sets of metadata mentioned above. Preferably, each entry comprises the downmix identifier.

In a further embodiment, the determining in step S103 may thus involve selecting a set among the plurality of sets in the payload based on the downmix selected by the decoder (or alternatively, based on the at least one DRCSet, EQSet, and downmix), wherein the one or more processing parameters determined in step S103 may be the one or more processing parameters relating to the identifiers in the selected set. That is, depending on settings (e.g., DRCSet, EQSet, and downmix) present in the decoder, the decoder can search a given payload for an appropriate set of parameters and identifiers, by matching the aforementioned settings to the identifiers. The parameters included in the set whose identifiers best match the settings can then be selected as the processing parameters for dynamic loudness adjustment.

In step S104, the determined one or more processing parameters may then be applied, by the decoder, to the decoded audio data to obtain processed audio data. The processed audio data, for example live real-time audio data, are thus properly loudness managed.

In step S105, the processed audio data may then be output for playback.

In an embodiment, the bitstream may further include additional metadata for static loudness adjustment to be applied to the decoded audio data. Static loudness adjustment refers in contrast to dynamic processing for real-time situations to processing performed for general loudness normalization.

Carrying the metadata for dynamic processing separately from the additional metadata for general loudness normalization allows to not have the "real-time" correction applied.

For example, when encoding and decoding for live real-time playout, the application of dynamic processing is desired to ensure that the live playout audio is properly loudness managed. But for a non-real-time playout, or a transcoding where the dynamic correction is not desired or required, the dynamic processing parameters determined from the metadata do not have to be applied.

By further keeping the (dynamic/real-time) metadata for dynamic processing separate from the additional metadata, the originally unprocessed content can be retained, if desired. The original audio is encoded along with the metadata. This allows the playback device to selectively apply the dynamic processing and to further enable playback of original audio content on high-end devices capable of playing back original audio.

Keeping the dynamic loudness metadata distinct from the long-term loudness measurement/information, such as contentLoudness (in ISO/IEC 23003-4) as described above has some advantages. If combined, the loudness of the content (or what it should be after the dynamic loudness metadata is applied) would not indicate the actual loudness of the content, as the metadata available would be a composite value. Besides removing this ambiguity of what the content loudness (or program or anchor loudness) is, there are some cases where this would be particularly beneficial:
Keeping the metadata for dynamic processing separate allows the decoder or playback device to turn off the application of dynamic processing and to apply an implemented real-time loudness leveler instead to avoid cascading leveling. This situation may occur, for example, if the device's own real-time leveling solution is superior to the one used with the audio codec or, for example, if the device's own real-time leveling solution cannot be disabled and therefore will always be active, resolution in further processing leading to a compromised playback experience.

Keeping the metadata for dynamic processing separate further allows transcoding to a codec that does not support dynamic loudness processing and one wishes to apply their own loudness processing prior to re-encoding.

Live to broadcast, with a single encode for a live feed would be a further example. The dynamic processing metadata may be used or stored for archive or on-demand services. Therefore, for the archive or on-demand services, a more accurate, or compliant loudness measurement, based on the entire program can be carried out, and the appropriate metadata reset.

For use-cases where a fixed target loudness is used throughout the workflow, for example in a R128 compliant situation where -23 LKFS is recommended, this is also beneficial. In this scenario, the addition of the dynamic processing metadata is a "safety" measure, where the content is assumed and close to the required target and the addition of the dynamic processing metadata is a secondary check. Thus, having the ability to turn it off is desirable.

### Encoding audio data and metadata for dynamic loudness adjustment

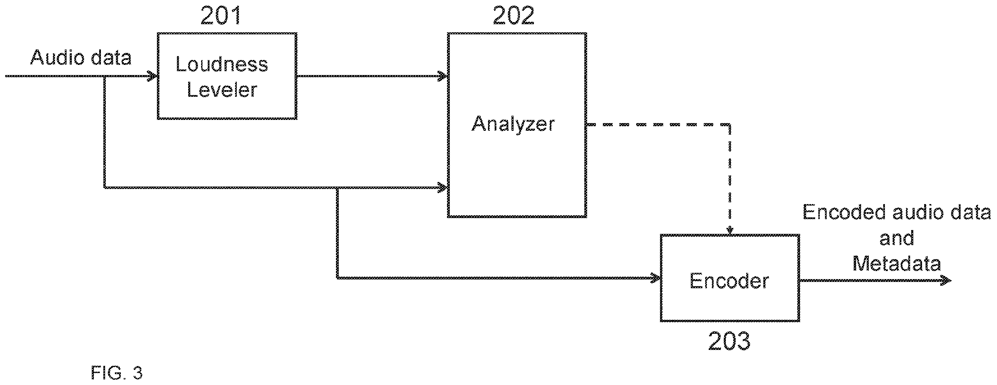

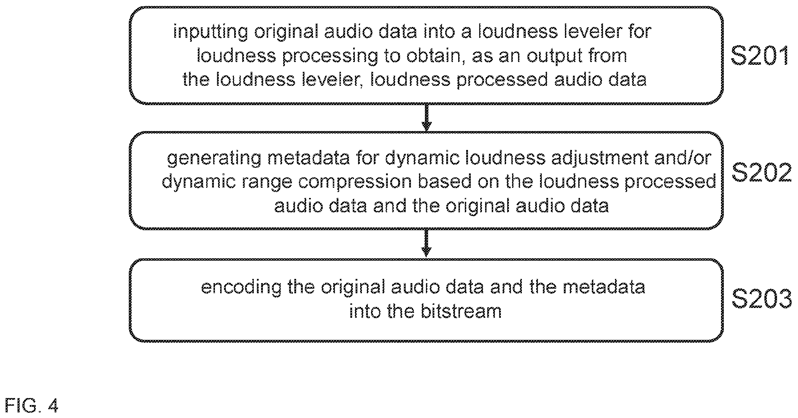

Referring to the examples of Figures 3 and 4, an encoder for encoding in a bitstream original audio data and metadata for dynamic loudness adjustment and dynamic range compression, DRC, is described which may comprise one or more processors and non-transitory memory configured to perform a method including the processes as illustrated in the steps in the example of Figure 4.

In step S201, original audio data may be input into a loudness leveler, 201, for loudness processing to obtain, as an output from the loudness leveler, 201, loudness processed audio data.

In step S202, metadata for dynamic loudness adjustment may then be generated based on the loudness processed audio data and the original audio data. Appropriate smoothing and time frames may be used to reduce artifacts.

In an embodiment, step S202 may include comparison of the loudness processed audio data to the original audio data, by an analyzer, 202, wherein the metadata may be generated based on a result of said comparison. The metadata thus generated can emulate the effect of the leveler at the decoder site. The metadata may include:
- Gain (wideband and/or multiband) processing parameters such that when applied to the original audio will produced loudness compliant audio for playback;
- Processing parameters describing the dynamics of the audio such as
   o Peak - sample and true peak
   o Short-term loudness values
   o Change of short-term loudness values.

In an embodiment, step S202 may further include measuring, by the analyzer, 202, the loudness over one or more pre-defined time periods, wherein the metadata may be generated further based on the measured loudness. In an embodiment, the measuring may comprise measuring overall loudness of the audio data. Alternatively, or additionally, in an embodiment, the measuring may comprise measuring loudness of dialogue in the audio data.

In step S203, the original audio data and the metadata may then be encoded into the bitstream. According to the invention, the bitstream is an MPEG-D DRC bitstream and the presence of the metadata is signaled based on MPEG-D DRC bitstream syntax. In this case, in an embodiment, a loudnessInfoSetExtension()-element may be used to carry the metadata as a payload as detailed further below.

According to the invention, the metadata comprises one or more metadata payloads, wherein each metadata payload includes a plurality of sets of parameters and identifiers, with each set including at least one of a DRCSet identifier, drcSetId, an EQSet identifier, eqSetId, and a downmix identifier, downmixId, in combination with one or more processing parameters relating to the identifiers in the set, and wherein the one or more processing parameters may be parameters for dynamic loudness adjustment by a decoder. In this case, in an embodiment, the at least one of the drcSetId, the eqSetId, and the downmixId may be related to at least one of a set of DRC sequences, DRCSet, a set of equalizer parameters, EQSet, and a downmix, to be selected by the decoder. In general, the metadata may be said to include a plurality of sets of metadata, with each set corresponding to a respective playback condition (e.g., to a different playback condition).

In an embodiment, the method may further include generating additional metadata for static loudness adjustment to be used by a decoder. Keeping the metadata for dynamic loudness processing and the additional metadata separate in the bitstream and encoding further the original audio data into the bitstream has several advantages as detailed above.

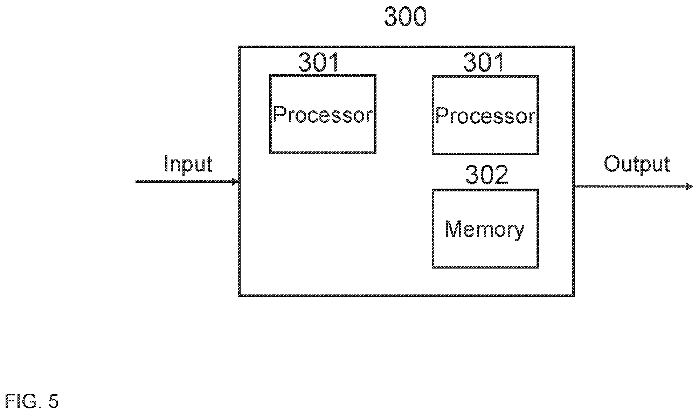

The methods described herein may be implemented on a decoder or an encoder, respectively, wherein the decoder and the encoder may comprise one or more processors and non-transitory memory configured to perform said methods. An example of a device having such processing capability is illustrated in the example of Figure 5 showing said device, 300, including two processors, 301, and non-transitory memory, 302.

It is noted that the methods described herein can further be implemented on a system of an encoder for encoding in a bitstream original audio data and metadata for dynamic loudness adjustment and optionally, dynamic range compression, DRC, and a decoder for metadata-based dynamic processing of audio data for playback as described herein.

The methods may further be implemented as a computer program product comprising a computer-readable storage medium with instructions adapted to cause the device to carry out said methods when executed by a device having processing capability. The computer program product may be stored on a computer-readable storage medium.

### MPEG-D DRC modified bitstream syntax

In the following, it will be described how the MPEG-D DRC bitstream syntax, as described in ISO/IEC 23003-4, may be modified in accordance with embodiments described herein.

The MPEG-D DRC syntax may be extended, e.g. the ***loudnessInfoSetExtension()*-**element shown in **Table 2** below, in order to also carry the dynamic processing metadata as a frame-based ***dynLoudComp*** update.

For example, another switch-case UNIDRCLOUDEXT_DYNLOUDCOMP may be added in the ***loudnessInfoSetExtension()***-element as shown in ***Table 1.*** The switch-case UNIDRCLOUDEXT_DYNLOUDCOMP may be used to identify a new element ***dynLoudComp()*** as shown in ***Table 5.*** The ***loudnessInfoSetExtension()***-element may be an extension of the **loudnessInfoSet**()-element as shown in ***Table 2.*** Further, the ***loudnessInfoSet()-***element may be part of the ***uniDRC**()-element* as shown in ***Table 3.***

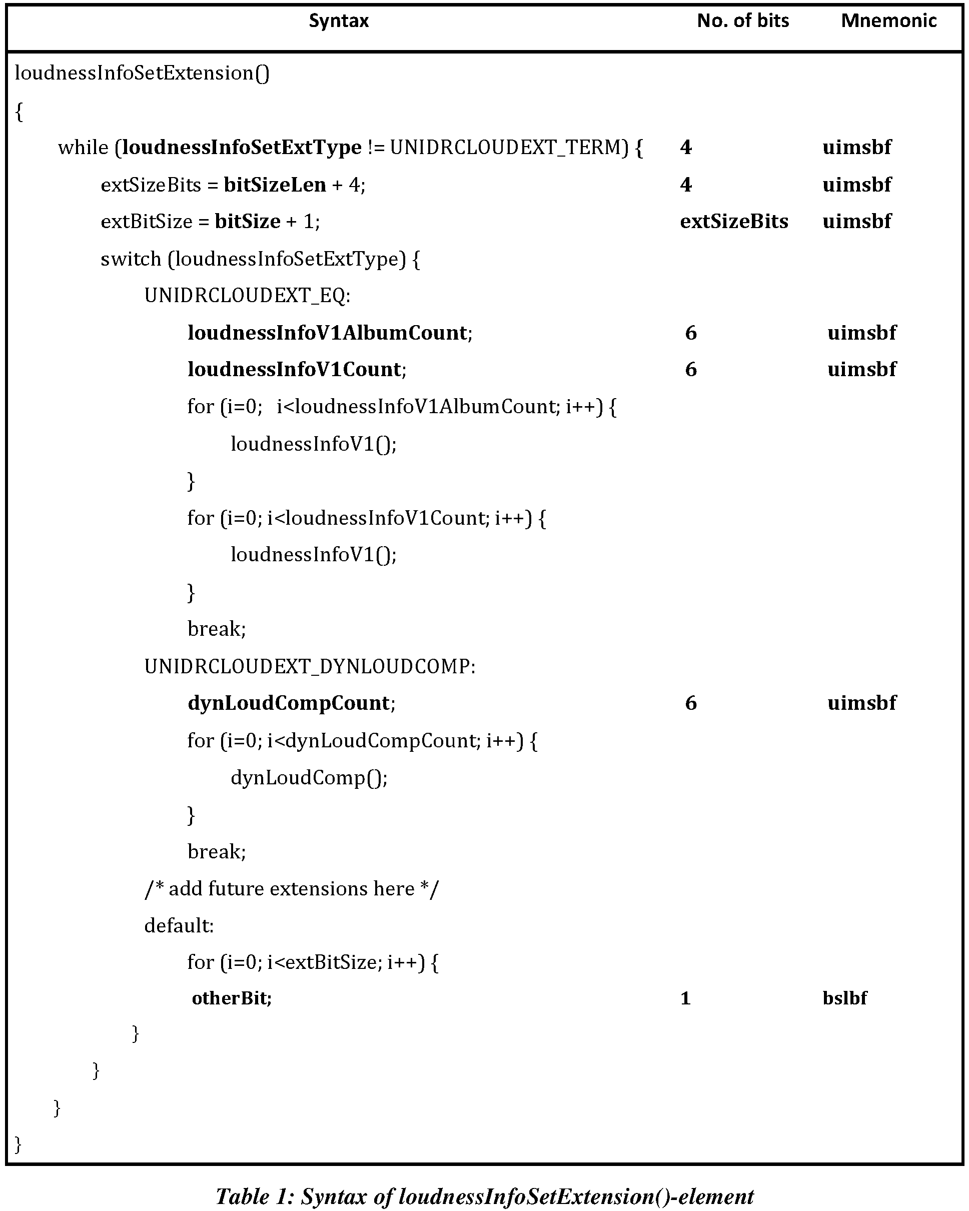

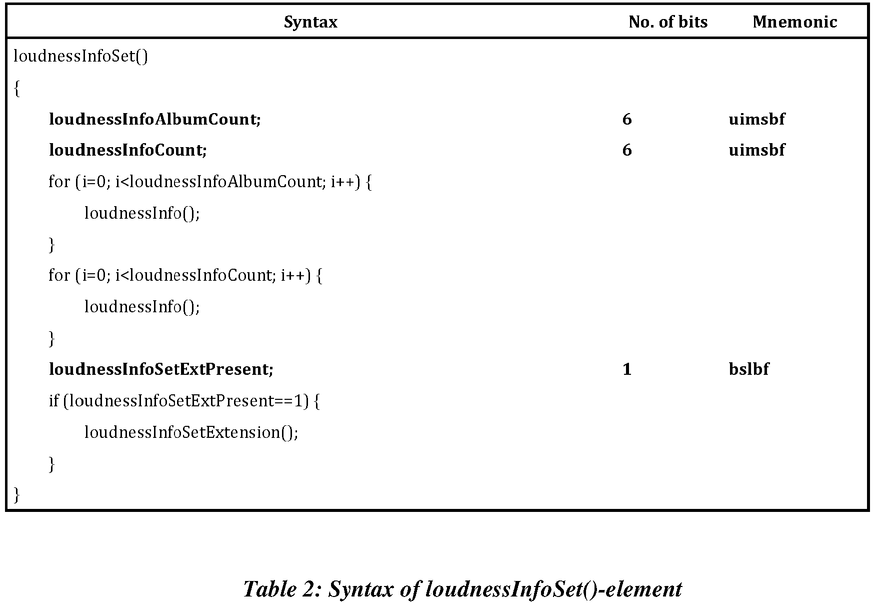

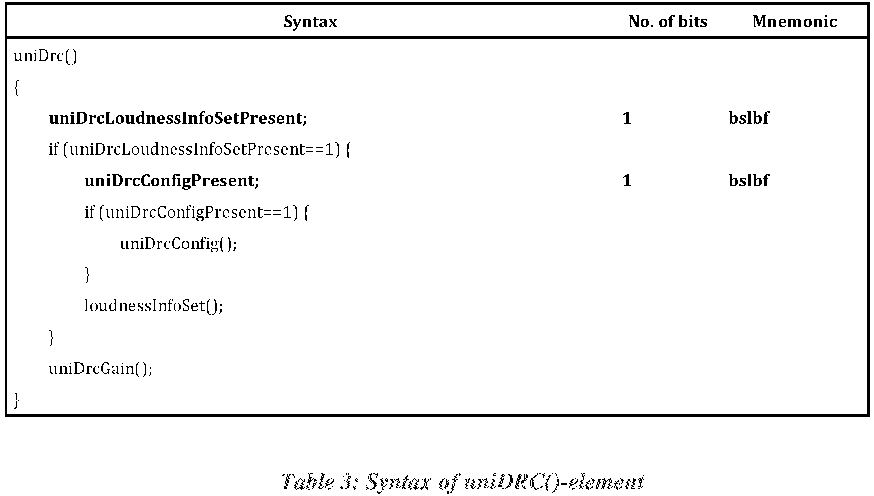

**Table 4: loudnessInfoSet extension types**

| **Symbol** | **Value of loudnessinfoSetExtType** | **Purpose** |
|---|---|---|
| UNIDRCLOUDEXT_TERM | 0×0 | Termination tag |
| UNIDRCLOUDEXT_EQ | 0×1 | Extension for equalization |
| UNIDRCLOUDEXT_DYNLOUDCOMP | 0×2 | Extension for dynamic processing |
| *(reserved)* | *(All remaining values)* | For future use |

### New dynLoudComp():

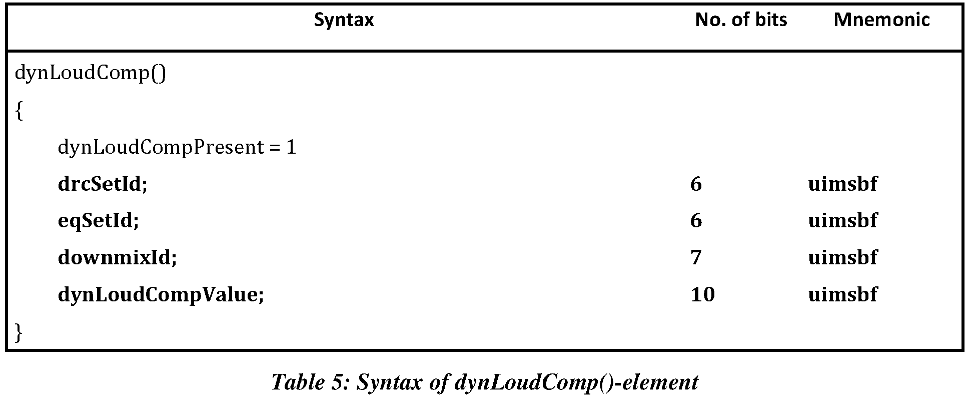

- The drcSetId enables dynLoudComp (relating to the metadata) to be applied per DRCset.
- The eqSetId enables dynLoudComp to be applied in combination with different settings for the equalization tool.
- The downmixId enables dynLoudComp to be applied per DownmixID.

In some cases, in addition to the above parameters, it may be beneficial for the dynLoudComp() element to also include a **methodDefinition** parameter (specified by, e.g., 4 bits) specifying a loudness measurement method used for deriving the dynamic program loudness metadata (e.g., anchor loudness, program loudness, short-term loudness, momentary loudness, etc.) and/or a **measurementSystem** parameter (specified by, e.g., 4 bits) specifying a loudness measurement system used for measuring the dynamic program loudness metadata (e.g., EBU R.128, ITU-R BS-1770 with or without preprocessing, ITU-R BS-1771, etc.). Such parameters may, e.g., be included in the dynLoudComp() element between the **downmixId** and **dynLoudCompValue** parameters.

### Alternative Syntax 1

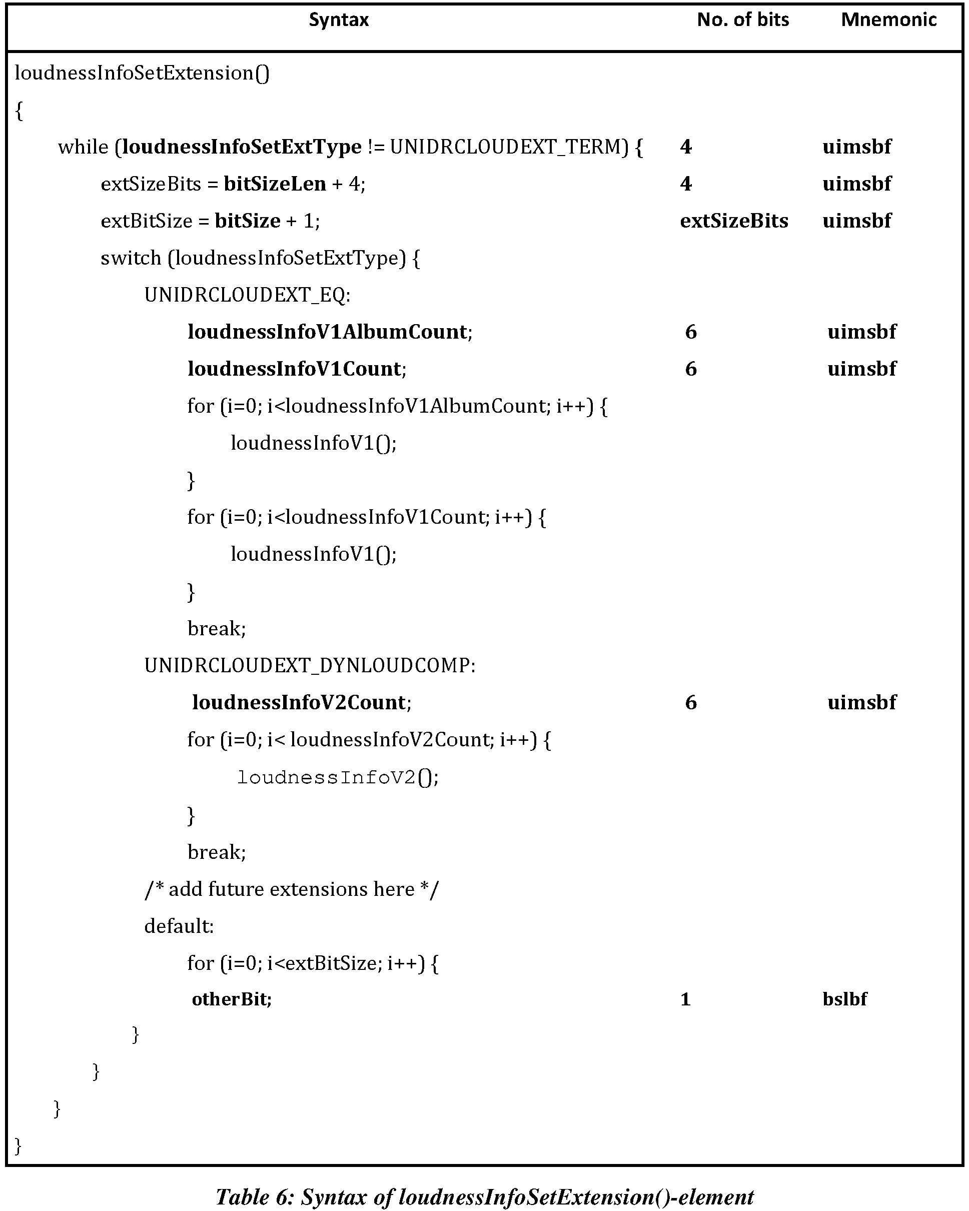

**Table 7: loudnessInfoSet extension types**

| **Symbol** | **Value of loudnessInfoSetExtType** | **Purpose** |
|---|---|---|
| UNIDRCLOUDEXT_TERM | 0×0 | Termination tag |
| UNIDRCLOUDEXT_EQ | 0×1 | Extension for equalization |
| UNIDRCLOUDEXT_DYNLOUDCOMP | 0×2 | Extension for dynamic processing |
| *(reserved)* | *(All remaining values)* | For future use |

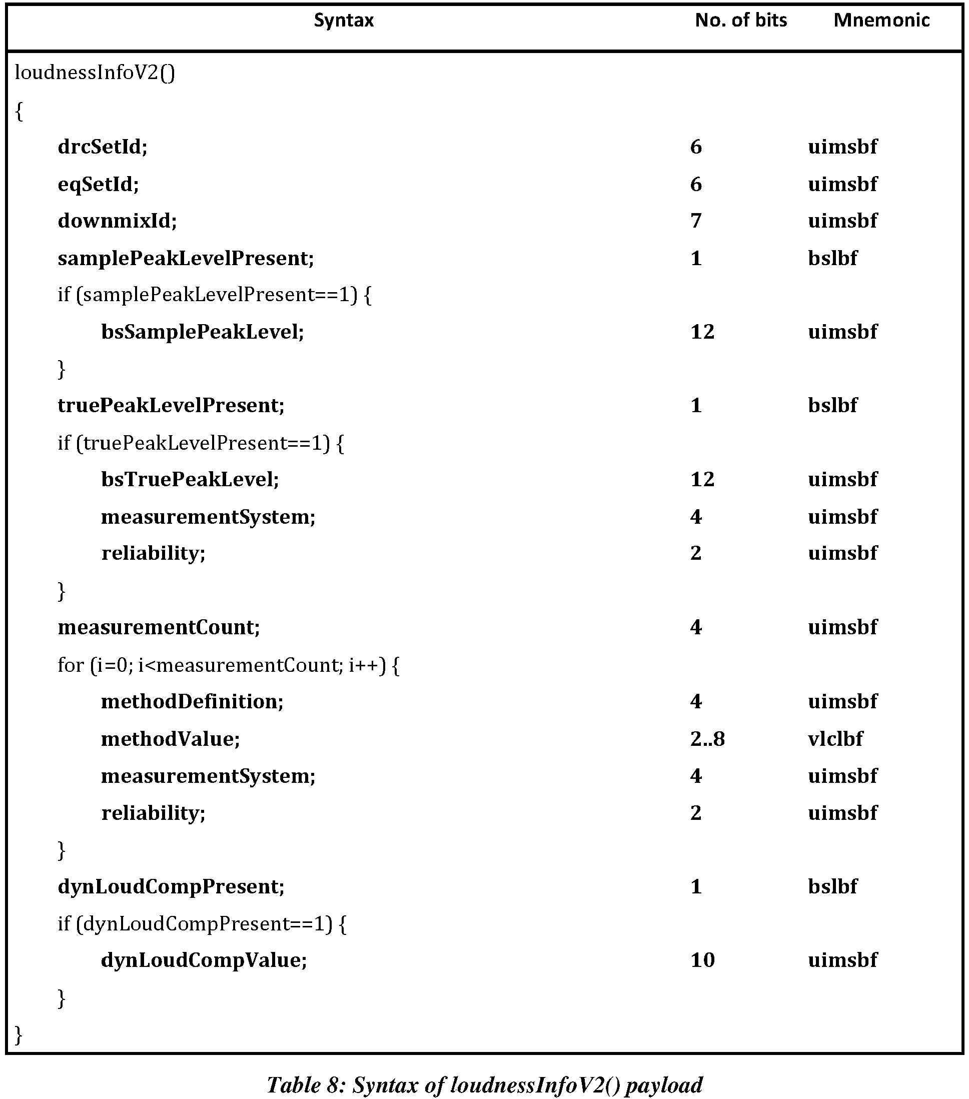

In some cases, it may be beneficial to modify the syntax shown above in Table 8 such that the **dynLoudCompPresent** and (if dynLoudCompPresent==1) **dynLoudCompValue** parameters follow the **reliability** parameter within the measurementCount loop of the loudnessInfoV2() payload, rather than being outside the measurementCount loop. Furthermore, it may also be beneficial to set dynLoudCompValue equal to 0 in cases where dynLoudCompPresent is 0.

### Alternative Syntax 2

Alternatively, the dynLoudComp()-element could be placed into the uniDrcGainExtension()-element.

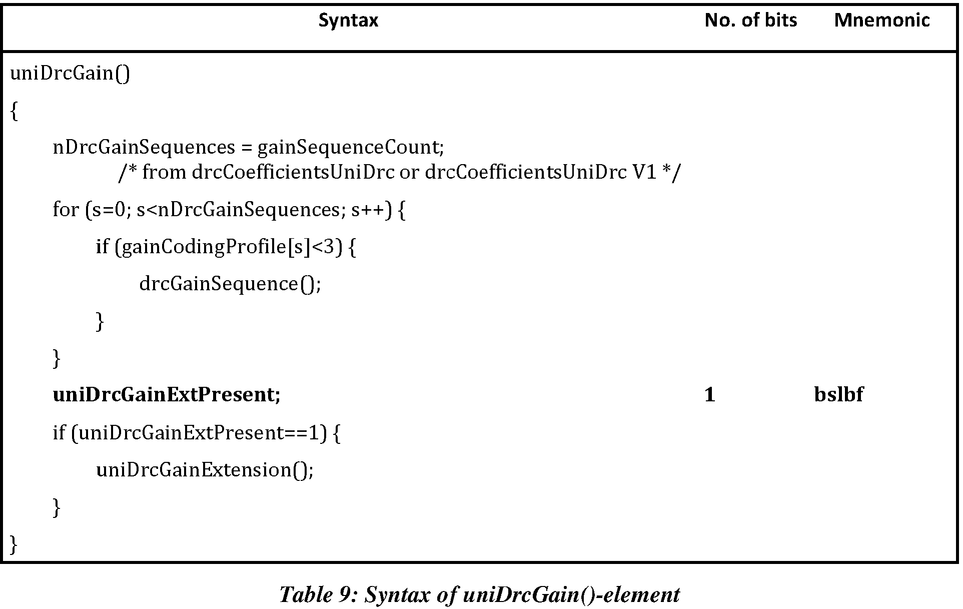

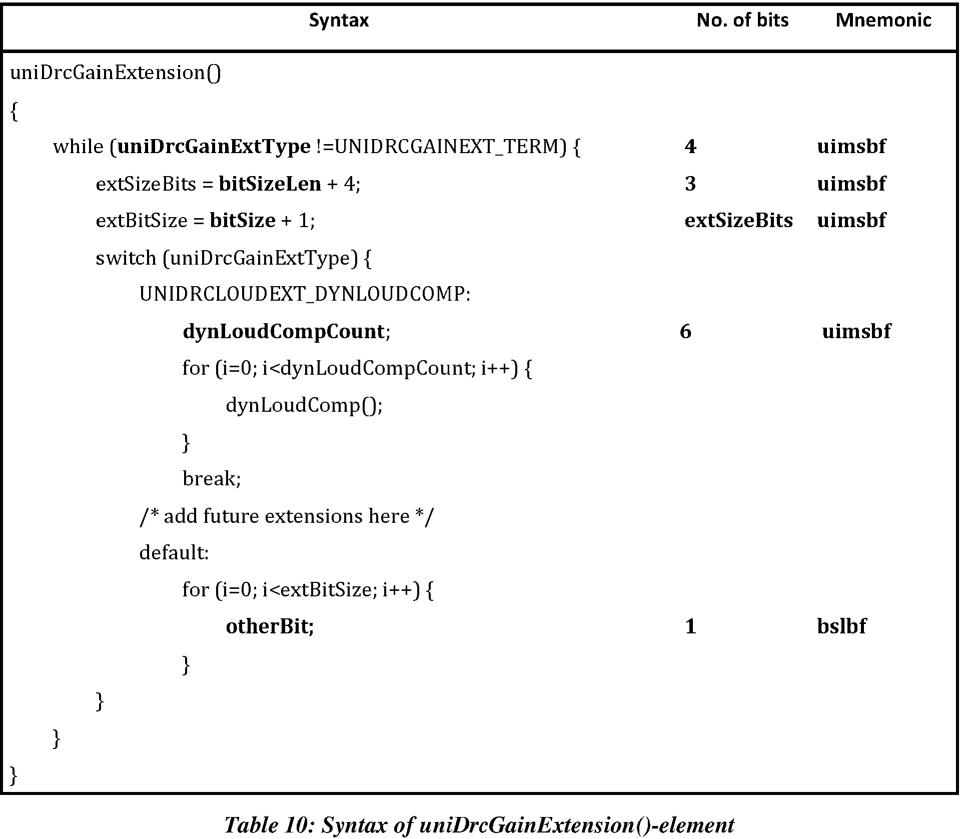

**Table 11: UniDrc gain extension types**

| **Symbol** | **Value of uniDrcGainExtType** | **Purpose** |
|---|---|---|
| UNIDRCGAINEXT_TERM | 0x0 | Termination tag |
| UNIDRCGAINEXT_DYNLOUDCOMP | 0×1 | Extension for dynamic processing |
| *(reserved)* | *(All remaining values)* | For future use |

### Semantics

| | |
|---|---|
| **dynLoudCompValue** | This field contains the value for *dynLoudCompDb.* The values are encoded according to the table below. The default value is 0 dB. |

**Table 12: Coding of dynLoudCompValue field**

| **Encoding** | **Size** | **Mnemonic** | **Value in [dB]** | **Approximate range** |
|---|---|---|---|---|
| *µ* | 10 bits | uimsbf | *dynLoudCompDb =* -16 + *µ*2⁻⁵ | -16 ... 16 dB, 0.0312 dB step size |

### Updated MPEG-D DRC Loudness Normalization Processing

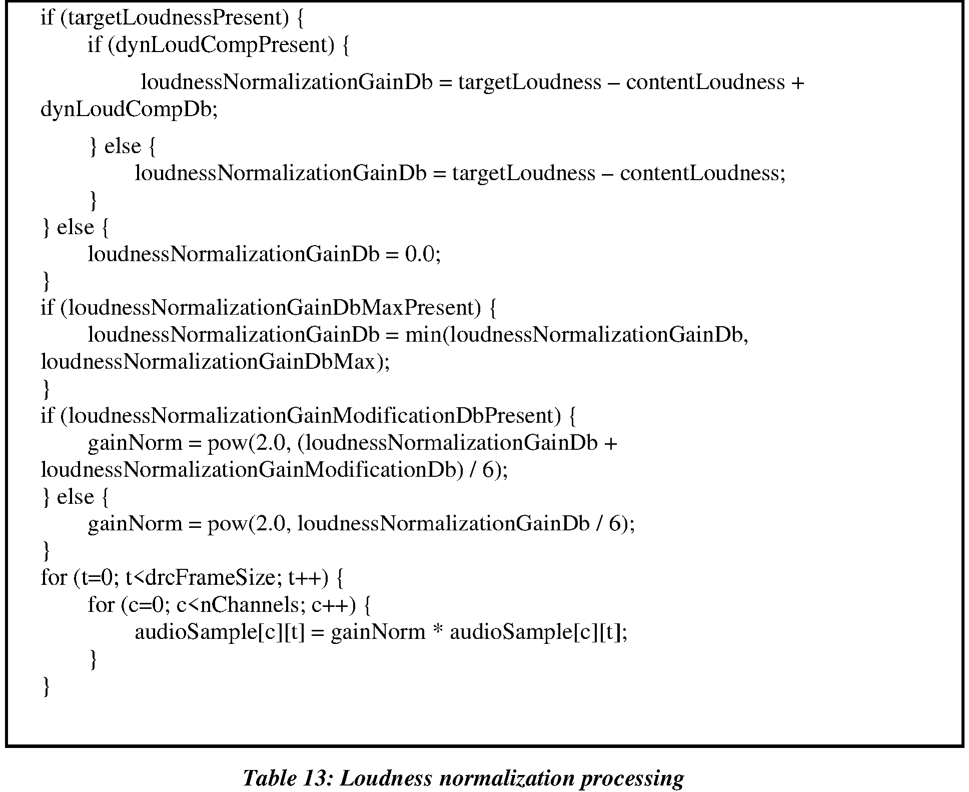

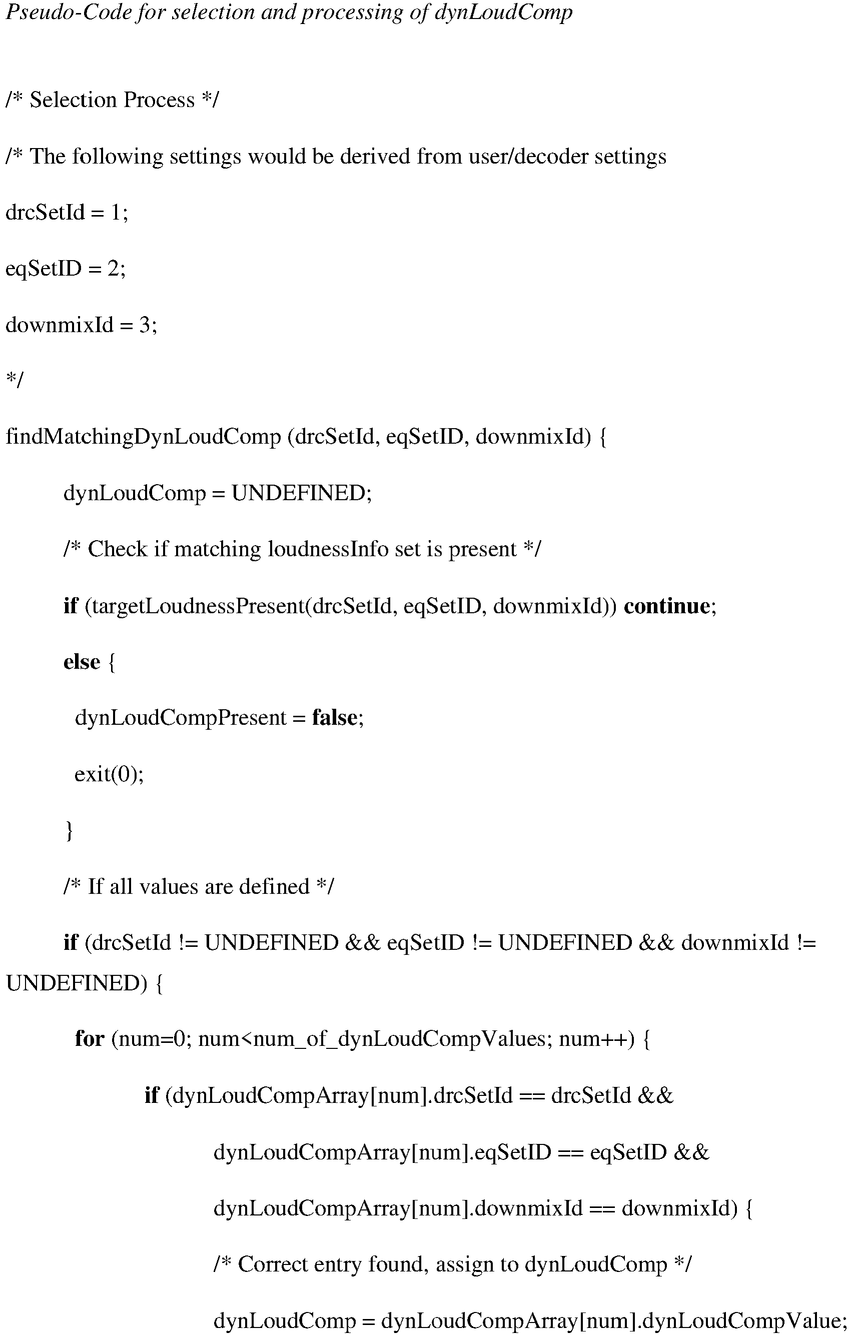

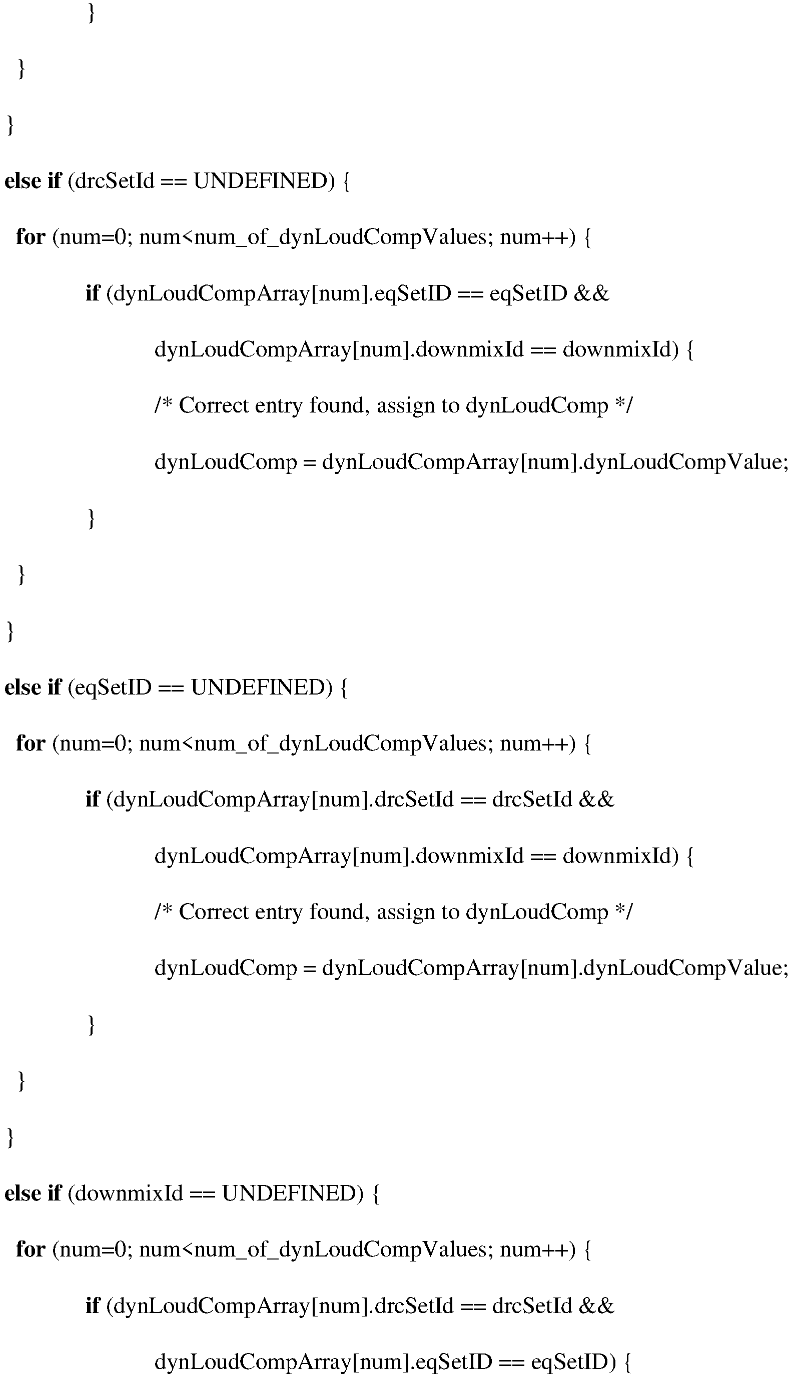

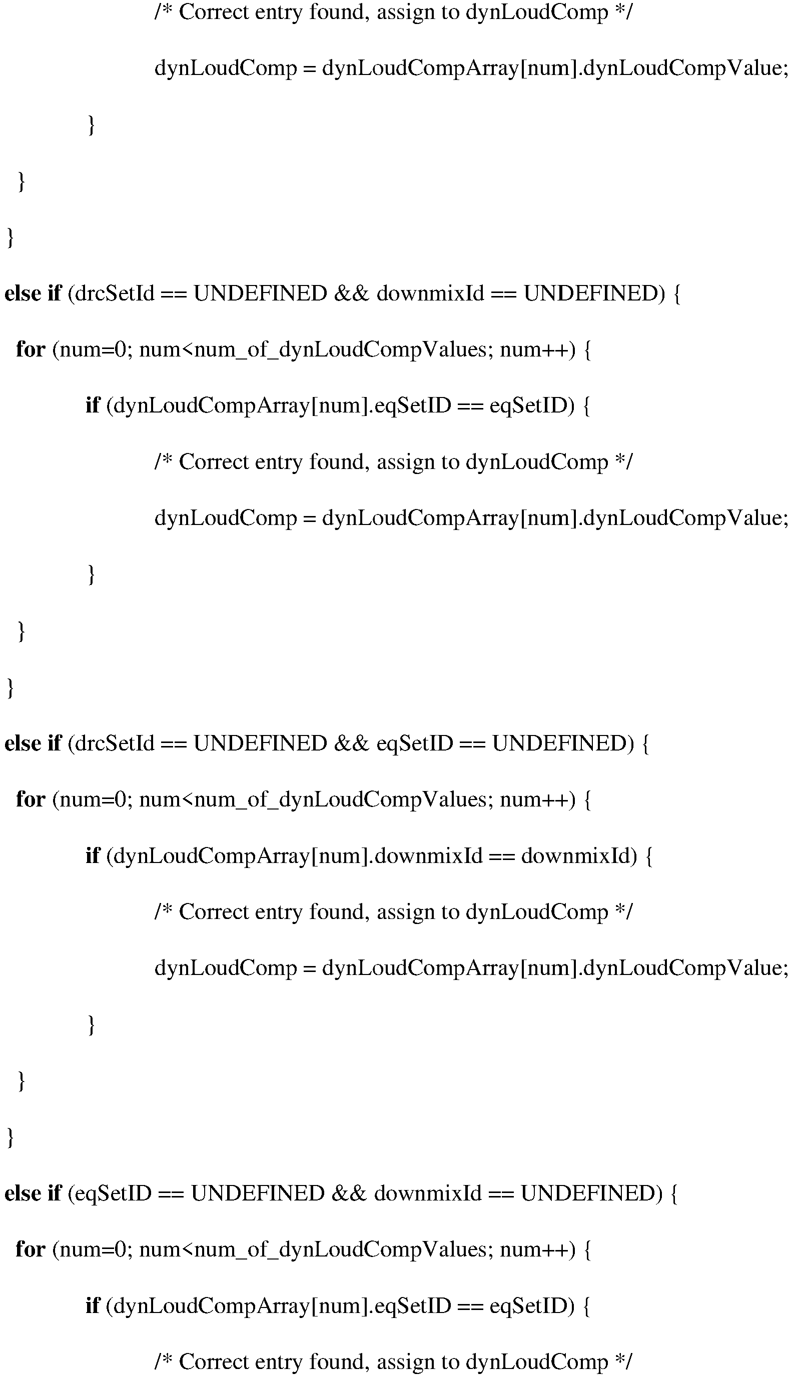

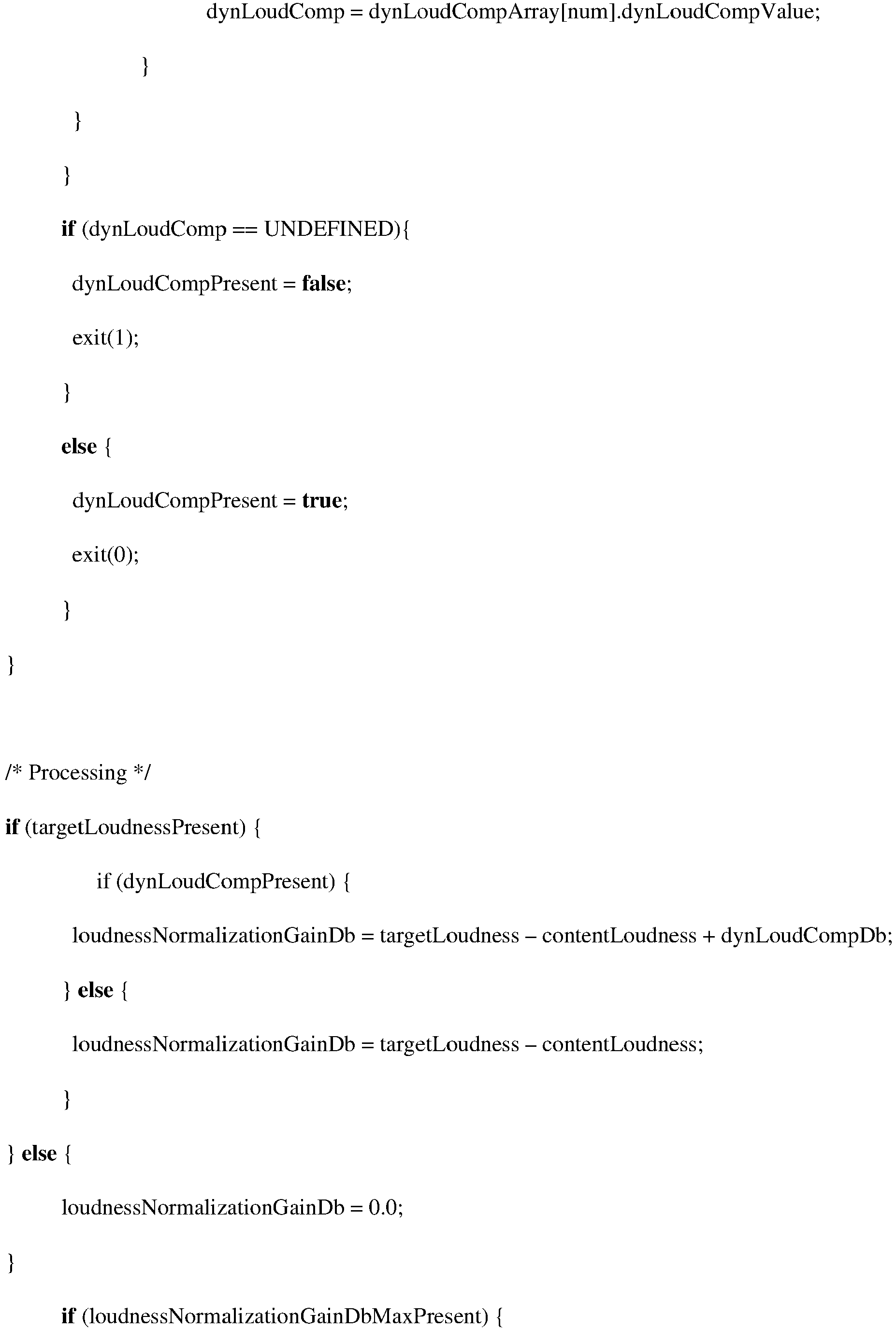

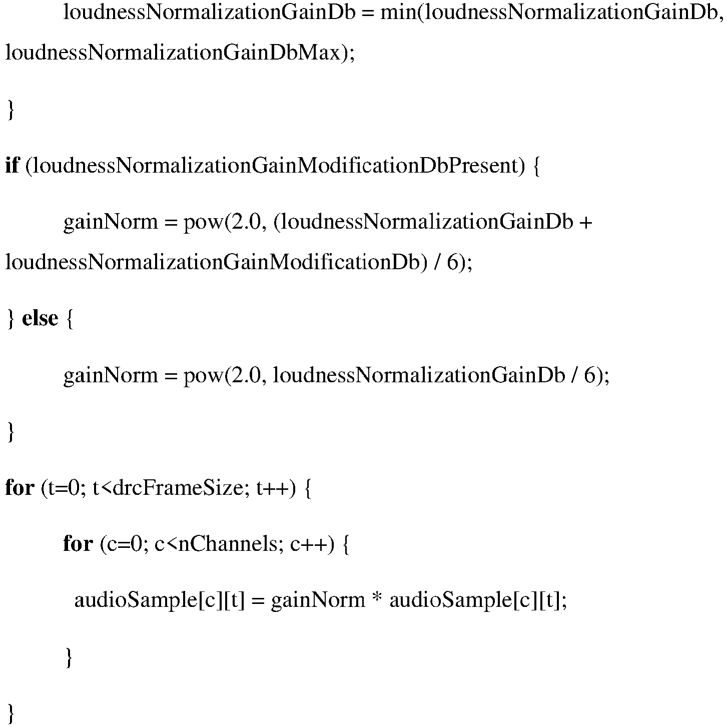

In some cases, in addition to the selection process shown in pseudo-code above (e.g., taking drcSetId, eqSetID and downmixId into consideration for selecting a dynLoudCompValue parameter), it may be beneficial for the selection process to also take a **methodDefinition** parameter and/or a **measurementSystem** parameter into consideration for selecting a dynLoudCompValue parameter.

### Alternative Updated MPEG-D DRC Loudness Normalization Processing

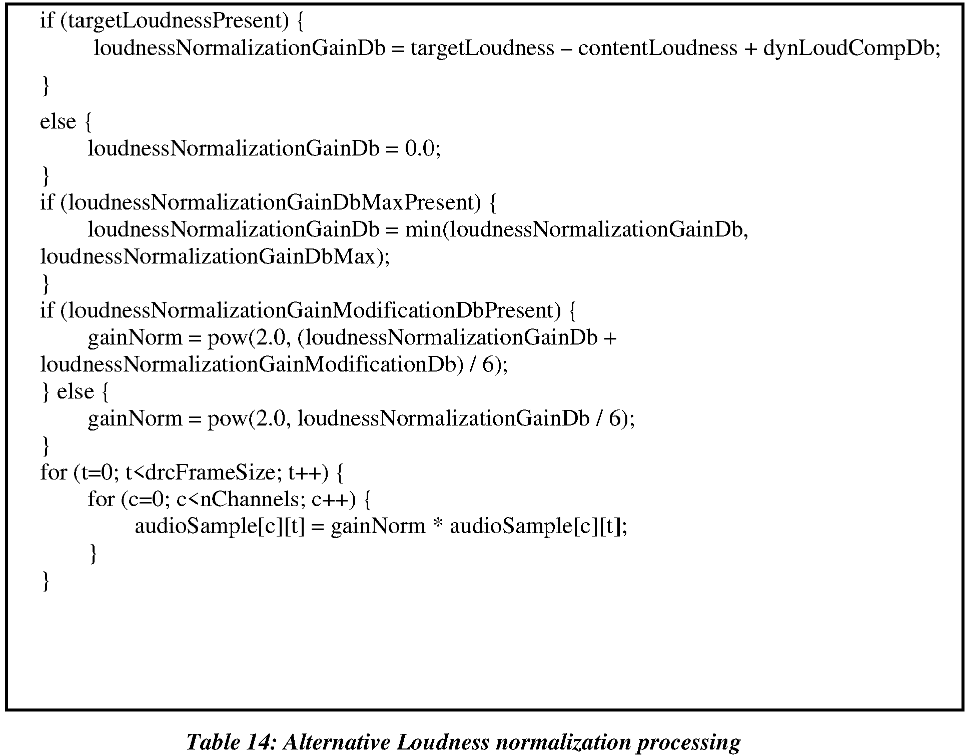

In cases where the alternative loudness normalization processing of Table 14 above is used, the loudness normalization processing pseudo-code described above may be replaced by the following alternative loudness normalization processing pseudo-code. Note that a default value of dynLoudCompDb, e.g., 0 dB, may be assumed to ensure that the value of dynLoudCompDb is defined, even for cases where dynamic loudness processing metadata is not present in the bitstream.

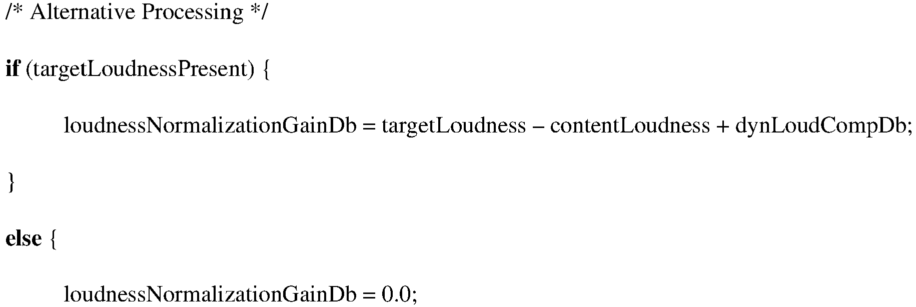

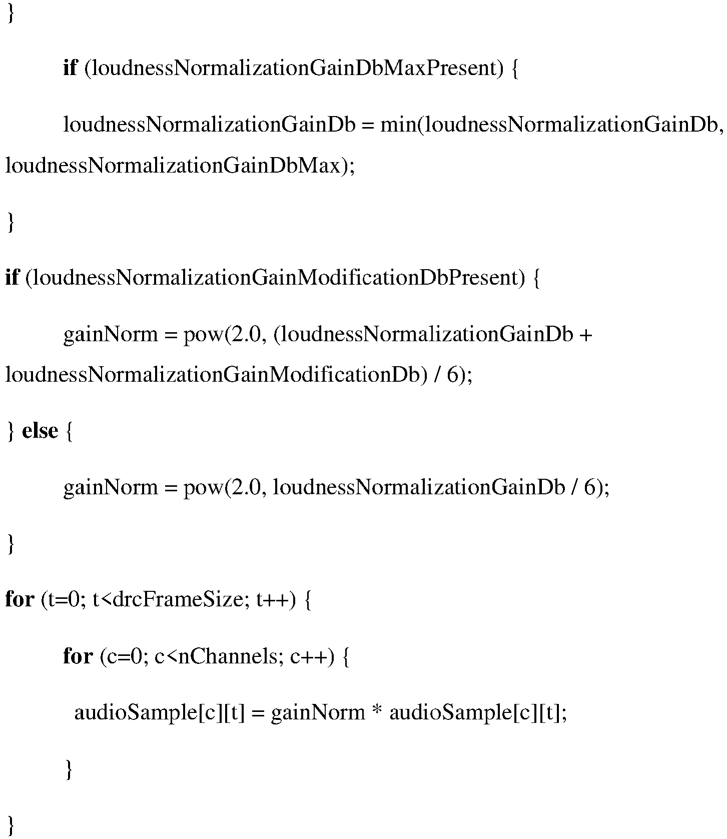

### Alternative Syntax 3

In some cases, it may be beneficial to combine the syntax described above in Table 1 - Table 5 with Alternative Syntax 1 described above in Table 6 - Table 8, as shown in the following Tables, to allow increased flexibility for transmission of the dynamic loudness processing values.

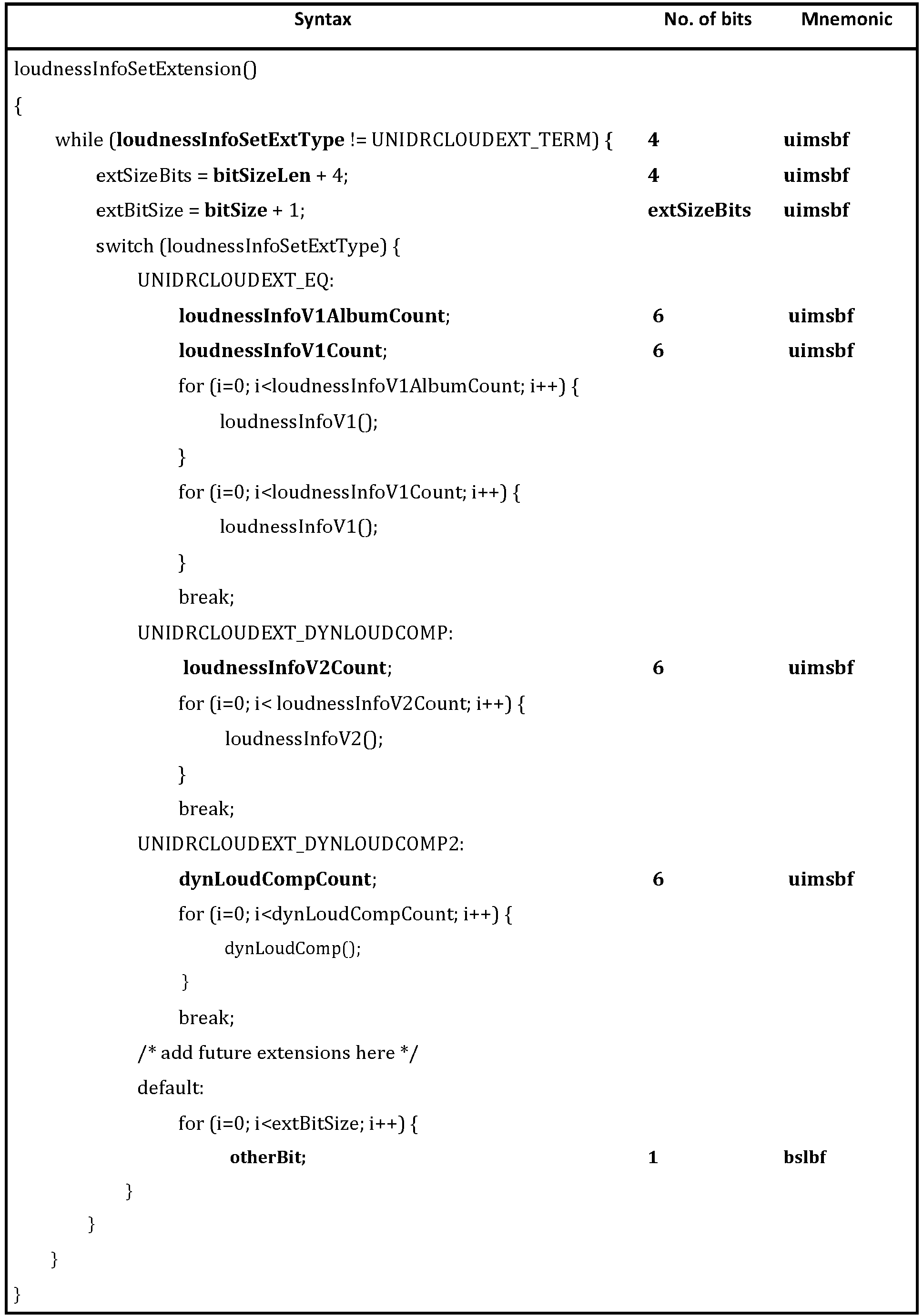

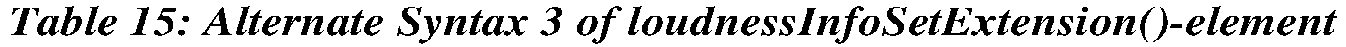

**Table 16: Alternate Syntax 3 of loudnessInfoSet extension types**

| **Symbol** | **Value of loudnessInfoSetExtType** | **Purpose** |
|---|---|---|
| UNIDRCLOUDEXT_TERM | 0×0 | Termination tag |
| UNIDRCLOUDEXT_EQ | 0×1 | Extension for equalization |
| UNIDRCLOUDEXT_DYNLOUDCOMP | 0×2 | Extension for dynamic processing |
| UNIDRCLOUDEXT_DYNLOUDCOMP2 | 0×3 | Extension for dynamic processing |
| *(reserved)* | *(All remaining values)* | For future use |

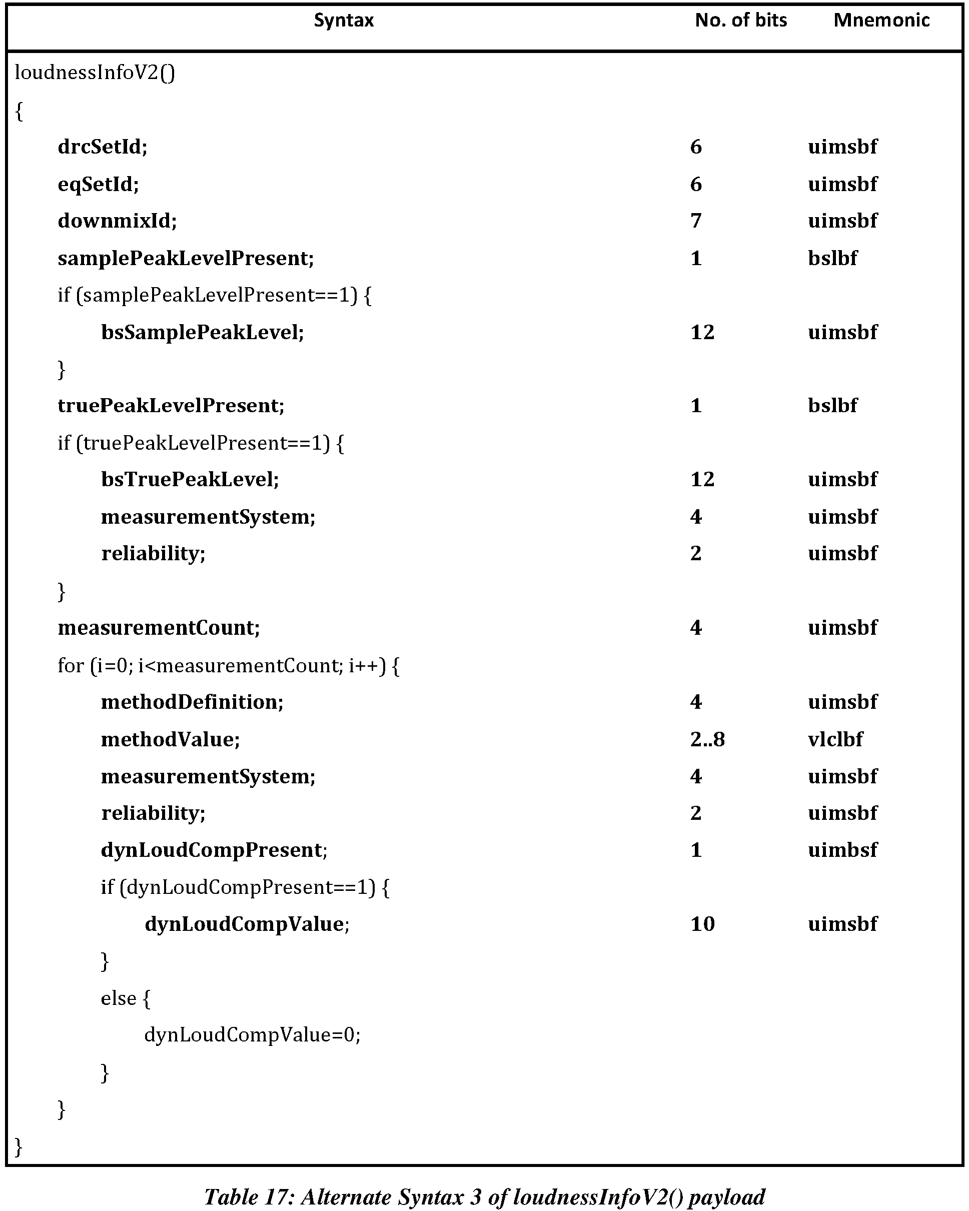

### Alternate Syntax 3 of dynLoudComp():

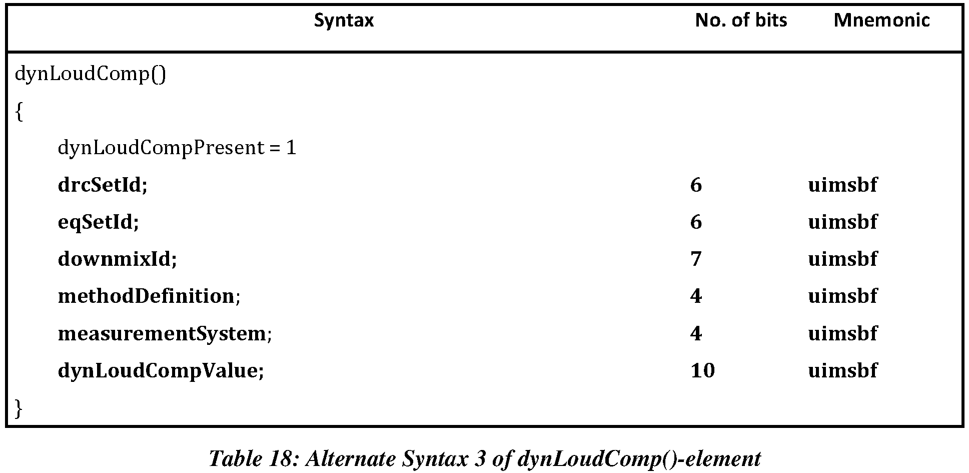

### Interface Extension Syntax

In some cases, it may be beneficial to allow control, e.g., by an end user, of whether or not dynamic loudness processing is performed, even when dynamic loudness processing information is present in a received bitstream. Such control may be provided by updating the MPEG-D DRC interface syntax to include an additional interface extension (e.g., UNIDRCINTERFACEEXT_DYNLOUD) which contains a revised loudness normalization control interface payload (e.g., loudnessNormalizationControlInterfaceV1()) as shown in the following tables.

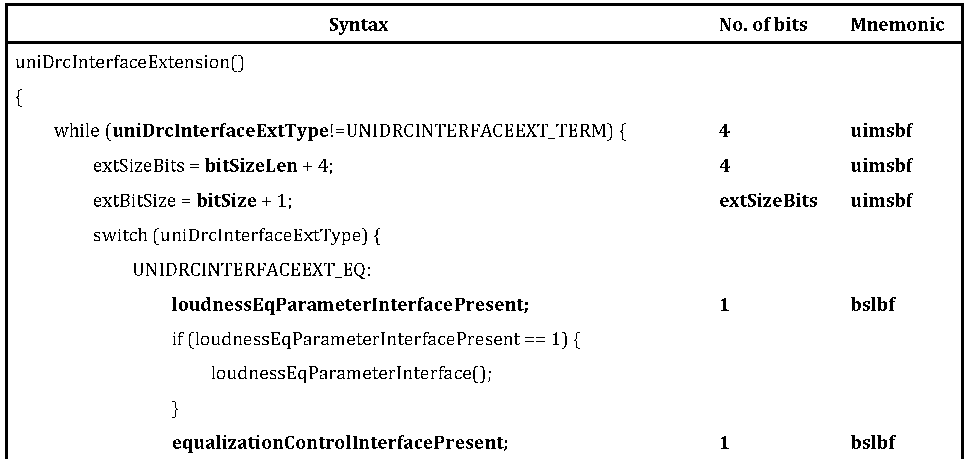

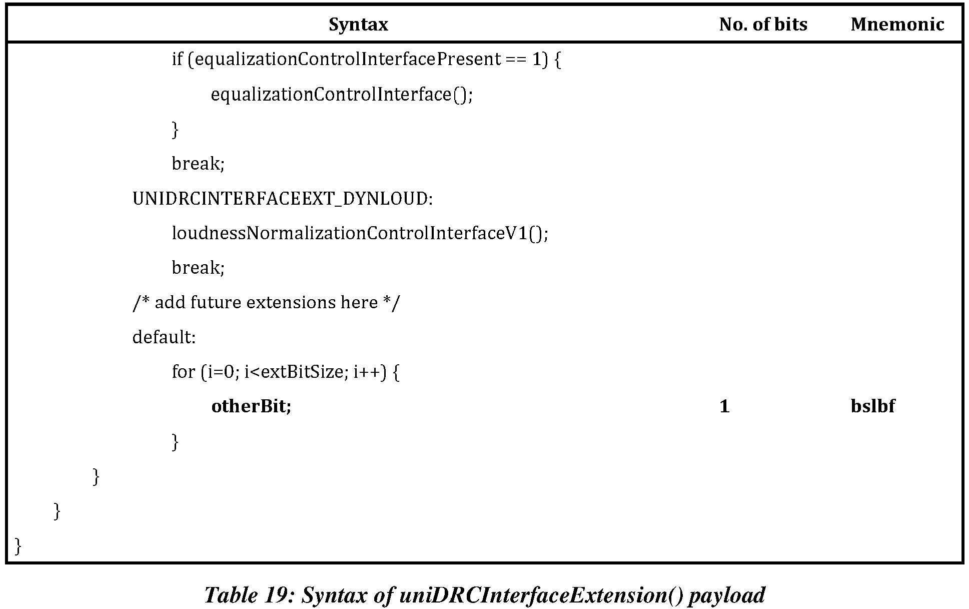

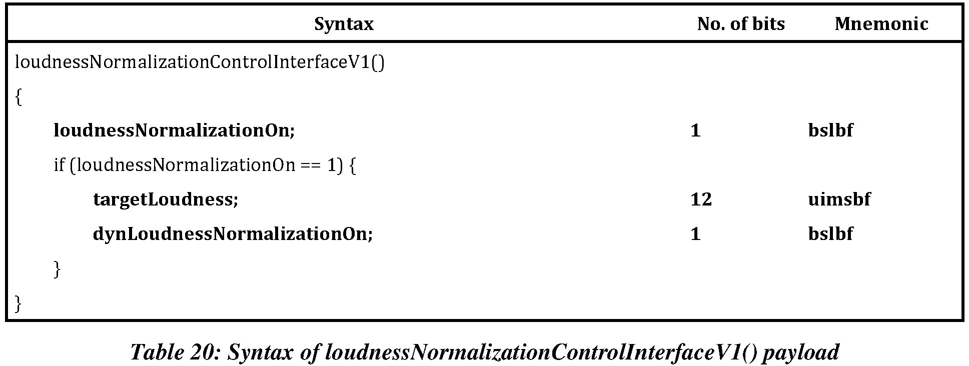

**Table 21: UniDRC Interface extension types**

| **Symbol** | **Value of uniDRCInterfaceExtType** | **Purpose** |
|---|---|---|
| UNIDRCINTERFACEEXT_TERM | 0×0 | Termination tag |
| UNIDRCINTERFACEEXT_EQ | 0×1 | Equalization Control |
| UNIDRCINTERFACEEXT_DYNLOUD | 0×2 | Dynamic Loudness Control |
| *(reserved)* | *(All remaining values)* | For future use |

### Interface Extension Semantics

| | |
|---|---|
| **loudnessNormalizationOn** | This flag signals if loudness normalization processing should be switched on or off. The default value is 0. If *loudnessNormalizationOn* == 0*, loudnessNormalizationGainDb* shall be set to 0 dB. |
| **targetLoudness** | This field contains the desired output loudness. The values are encoded according to the following Table. |

**Table 22: Coding of targetLoudness field**

| **Encoding** | **Size** | **Mnemonic** | **Value in [dB]** | **Approximate range** |
|---|---|---|---|---|
| *µ* | 12 bits | uimsbf | *L_{TL}* = -*µ*2 ⁻⁵ | -128 ... 0 dB, 0.0312 dB step size |

| | |
|---|---|
| **dynLoudnessNormalizationOn** | This flag signals if dynamic loudness normalization processing should be switched on or off. The default value is 0. If *dynLoudnessNormalizationOn* == 0, *dynloudnessNormalizationGainDb* shall be set to 0 dB. |

### Interpretation

Unless specifically stated otherwise, as apparent from the following discussions, it is appreciated that throughout the disclosure discussions utilizing terms such as "processing", "computing", "determining", "analyzing" or the like, refer to the action and/or processes of a computer or computing system, or similar electronic computing devices, that manipulate and/or transform data represented as physical, such as electronic, quantities into other data similarly represented as physical quantities.

In a similar manner, the term "processor" may refer to any device or portion of a device that processes electronic data, e.g., from registers and/or memory to transform that electronic data into other electronic data that, e.g., may be stored in registers and/or memory. A "computer" or a "computing machine" or a "computing platform" may include one or more processors.

The methodologies described herein are, in one example embodiment, performable by one or more processors that accept computer-readable (also called machine-readable) code containing a set of instructions that when executed by one or more of the processors carry out at least one of the methods described herein. Any processor capable of executing a set of instructions (sequential or otherwise) that specify actions to be taken are included. Thus, one example is a typical processing system that includes one or more processors. Each processor may include one or more of a CPU, a graphics processing unit, and a programmable DSP unit. The processing system further may include a memory subsystem including main RAM and/or a static RAM, and/or ROM. A bus subsystem may be included for communicating between the components. The processing system further may be a distributed processing system with processors coupled by a network. If the processing system requires a display, such a display may be included, e.g., a liquid crystal display (LCD) or a cathode ray tube (CRT) display. If manual data entry is required, the processing system also includes an input device such as one or more of an alphanumeric input unit such as a keyboard, a pointing control device such as a mouse, and so forth. The processing system may also encompass a storage system such as a disk drive unit. The processing system in some configurations may include a sound output device, and a network interface device. The memory subsystem thus includes a computer-readable carrier medium that carries computer-readable code (e.g., software) including a set of instructions to cause performing, when executed by one or more processors, one or more of the methods described herein. Note that when the method includes several elements, e.g., several steps, no ordering of such elements is implied, unless specifically stated. The software may reside in the hard disk, or may also reside, completely or at least partially, within the RAM and/or within the processor during execution thereof by the computer system. Thus, the memory and the processor also constitute computer-readable carrier medium carrying computer-readable code. Furthermore, a computer-readable carrier medium may form, or be included in a computer program product.

In alternative example embodiments, the one or more processors operate as a standalone device or may be connected, e.g., networked to other processor(s), in a networked deployment, the one or more processors may operate in the capacity of a server or a user machine in server-user network environment, or as a peer machine in a peer-to-peer or distributed network environment. The one or more processors may form a personal computer (PC), a tablet PC, a Personal Digital Assistant (PDA), a cellular telephone, a web appliance, a network router, switch or bridge, or any machine capable of executing a set of instructions (sequential or otherwise) that specify actions to be taken by that machine.

Note that the term "machine" shall also be taken to include any collection of machines that individually or jointly execute a set (or multiple sets) of instructions to perform any one or more of the methodologies discussed herein.

Thus, one example embodiment of each of the methods described herein is in the form of a computer-readable carrier medium carrying a set of instructions, e.g., a computer program that is for execution on one or more processors, e.g., one or more processors that are part of web server arrangement. Thus, as will be appreciated by those skilled in the art, example embodiments of the present disclosure may be embodied as a method, an apparatus such as a special purpose apparatus, an apparatus such as a data processing system, or a computer-readable carrier medium, e.g., a computer program product. The computer-readable carrier medium carries computer readable code including a set of instructions that when executed on one or more processors cause the processor or processors to implement a method. Accordingly, aspects of the present disclosure may take the form of a method, an entirely hardware example embodiment, an entirely software example embodiment or an example embodiment combining software and hardware aspects. Furthermore, the present disclosure may take the form of carrier medium (e.g., a computer program product on a computer-readable storage medium) carrying computer-readable program code embodied in the medium.

The software may further be transmitted or received over a network via a network interface device. While the carrier medium is in an example embodiment a single medium, the term "carrier medium" should be taken to include a single medium or multiple media (e.g., a centralized or distributed database, and/or associated caches and servers) that store the one or more sets of instructions. The term "carrier medium" shall also be taken to include any medium that is capable of storing, encoding or carrying a set of instructions for execution by one or more of the processors and that cause the one or more processors to perform any one or more of the methodologies of the present disclosure. A carrier medium may take many forms, including but not limited to, non-volatile media, volatile media, and transmission media. Non-volatile media includes, for example, optical, magnetic disks, and magneto-optical disks. Volatile media includes dynamic memory, such as main memory. Transmission media includes coaxial cables, copper wire and fiber optics, including the wires that comprise a bus subsystem. Transmission media may also take the form of acoustic or light waves, such as those generated during radio wave and infrared data communications. For example, the term "carrier medium" shall accordingly be taken to include, but not be limited to, solid-state memories, a computer product embodied in optical and magnetic media; a medium bearing a propagated signal detectable by at least one processor or one or more processors and representing a set of instructions that, when executed, implement a method; and a transmission medium in a network bearing a propagated signal detectable by at least one processor of the one or more processors and representing the set of instructions.

It will be understood that the steps of methods discussed are performed in one example embodiment by an appropriate processor (or processors) of a processing (e.g., computer) system executing instructions (computer-readable code) stored in storage. It will also be understood that the disclosure is not limited to any particular implementation or programming technique and that the disclosure may be implemented using any appropriate techniques for implementing the functionality described herein. The disclosure is not limited to any particular programming language or operating system.

Reference throughout this disclosure to "one embodiment", "some embodiments" or "an example embodiment" means that a particular feature, structure or characteristic described in connection with the embodiment is included in at least one embodiment of the present disclosure. Thus, appearances of the phrases "in one embodiment", "in some embodiments" or "in an example embodiment" in various places throughout this disclosure are not necessarily all referring to the same example embodiment. Furthermore, the particular features, structures or characteristics may be combined in any suitable manner, as would be apparent to one of ordinary skill in the art from this disclosure, in one or more example embodiments.

As used herein, unless otherwise specified the use of the ordinal adjectives "first", "second", "third", etc., to describe a common object, merely indicate that different instances of like objects are being referred to and are not intended to imply that the objects so described must be in a given sequence, either temporally, spatially, in ranking, or in any other manner.

In the claims below and the description herein, any one of the terms comprising, comprised of or which comprises is an open term that means including at least the elements/features that follow, but not excluding others. Thus, the term comprising, when used in the claims, should not be interpreted as being limitative to the means or elements or steps listed thereafter. For example, the scope of the expression a device comprising A and B should not be limited to devices consisting only of elements A and B. Any one of the terms including or which includes or that includes as used herein is also an open term that also means including at least the elements/features that follow the term, but not excluding others. Thus, including is synonymous with and means comprising.

It should be appreciated that in the above description of example embodiments of the disclosure, various features of the disclosure are sometimes grouped together in a single example embodiment, Fig., or description thereof for the purpose of streamlining the disclosure and aiding in the understanding of one or more of the various inventive aspects. This method of disclosure, however, is not to be interpreted as reflecting an intention that the claims require more features than are expressly recited in each claim. Rather, as the following claims reflect, inventive aspects lie in less than all features of a single foregoing disclosed example embodiment. Thus, the claims following the Description are hereby expressly incorporated into this Description, with each claim standing on its own as a separate example embodiment of this disclosure.

In the description provided herein, numerous specific details are set forth. However, it is understood that example embodiments of the disclosure may be practiced without these specific details. In other instances, well-known methods, structures and techniques have not been shown in detail in order not to obscure an understanding of this description.

Thus, while there has been described what are believed to be the best modes of the disclosure, those skilled in the art will recognize that other and further modifications may be made thereto without departing from the scope of the disclosure. For example, any formulas given above are merely representative of procedures that may be used. Functionality may be added or deleted from the block diagrams and operations may be interchanged among functional blocks. Steps may be added or deleted to methods described within the scope of the present disclosure.

## Claims

1. A method of metadata-based dynamic processing of audio data for playback, the method including:
receiving (S101), by a decoder, a bitstream including audio data and metadata for dynamic loudness adjustment, wherein the metadata for dynamic loudness adjustment comprises a plurality of sets of metadata, wherein each set of metadata corresponds to a respective playback condition;
decoding (S102), by the decoder, the audio data and the metadata to obtain decoded audio data and the metadata;
selecting (S103), in response to playback condition information provided to the decoder, a set of metadata corresponding to a specific playback condition, and extracting, from the selected set of metadata, one or more processing parameters for dynamic loudness adjustment;
applying (S104) the extracted one or more processing parameters to the decoded audio data to obtain processed audio data;
outputting (S105) the processed audio data for playback, and
wherein the selected set of metadata includes a set of dynamic range compression, DRC, sequences, DRCSet,
wherein the bitstream is an MPEG-D DRC bitstream and the presence of metadata is signaled based on MPEG-D DRC bitstream syntax, and
wherein the metadata comprises one or more metadata payloads, wherein each metadata payload includes a plurality of sets of parameters and identifiers, with each set including a respective downmix identifier, downmixId, in combination with one or more processing parameters relating to the downmix identifier in the set.

2. The method according to claim 1, wherein a loudnessInfoSetExtension()-element is used to carry the metadata as a payload.

3. A decoder (100) for metadata-based dynamic processing of audio data for playback, wherein the decoder (100) comprises one or more processors and non-transitory memory configured to perform a method including:
receiving (S101), by the decoder (100), a bitstream including audio data and metadata for dynamic loudness adjustment, wherein the metadata for dynamic loudness adjustment comprises a plurality of sets of metadata, wherein each set of metadata corresponds to a respective playback condition;
decoding (S102), by the decoder (100), the audio data and the metadata to obtain decoded audio data and the metadata;
selecting (S 103), in response to a playback condition provided to the decoder a set of metadata corresponding to a specific playback condition, and extracting, from the selected set of metadata, one or more processing parameters for dynamic loudness adjustment;
applying (S104) the extracted one or more processing parameters to the decoded audio data to obtain processed audio data;
outputting (S105) the processed audio data for playback, and
wherein the selected set of metadata includes a set of dynamic range compression, DRC, sequences, DRCSet,
wherein the bitstream is an MPEG-D DRC bitstream and the presence of metadata is signaled based on MPEG-D DRC bitstream syntax, and
wherein the metadata comprises one or more metadata payloads, wherein each metadata payload includes a plurality of sets of parameters and identifiers, with each set including a respective downmix identifier, downmixId, in combination with one or more processing parameters relating to the downmix identifier in the set.

4. A method of encoding audio data and metadata for dynamic loudness adjustment into a bitstream, the method including:
inputting (S201) original audio data into a loudness leveler for loudness processing to obtain, as an output from the loudness leveler, loudness processed audio data;
generating (S202) the metadata for dynamic loudness adjustment based on the loudness processed audio data and the original audio data; and
encoding (S203) the original audio data and the metadata into the bitstream,
wherein the metadata comprises a plurality of sets of metadata, wherein each set of metadata corresponds to a respective playback condition,
wherein the bitstream is an MPEG-D DRC bitstream and the presence of metadata is signaled based on MPEG-D DRC bitstream syntax, and
wherein the metadata comprises one or more metadata payloads, wherein each metadata payload includes a plurality of sets of parameters and identifiers, with each set including a respective downmix identifier, downmixId, in combination with one or more processing parameters relating to the downmix identifier in the set, and wherein the one or more processing parameters are parameters for dynamic loudness adjustment by a decoder.

5. The method according to claim 4, wherein the method further includes generating additional metadata for static loudness adjustment to be used by a decoder.

6. The method according to claim 4 or 5, wherein said generating metadata includes comparison of the loudness processed audio data to the original audio data, and wherein the metadata is generated based on a result of said comparison.

7. The method according to claim 6, wherein said generating metadata further includes measuring the loudness over one or more pre-defined time periods, and wherein the metadata is generated further based on the measured loudness.

8. The method according to claim 7, wherein the measuring comprises measuring overall loudness of the audio data.

9. The method according to claim 8, wherein the measuring comprises measuring loudness of dialogue in the audio data.

10. The method according to claim 4, wherein a loudnessInfoSetExtension()-element is used to carry the metadata as a payload.

11. An encoder (203) for encoding in a bitstream original audio data and metadata for dynamic loudness adjustment, wherein the encoder (203) comprises one or more processors and non-transitory memory configured to perform a method including:
inputting original audio data into a loudness leveler (201) for loudness processing to obtain, as an output from the loudness leveler (201), loudness processed audio data;
generating the metadata for dynamic loudness adjustment based on the loudness processed audio data and the original audio data; and
encoding the original audio data and the metadata into the bitstream,
wherein the metadata comprises a plurality of sets of metadata, wherein each set of metadata corresponds to a respective playback condition,
wherein the bitstream is an MPEG-D DRC bitstream and the presence of metadata is signaled based on MPEG-D DRC bitstream syntax, and
wherein the metadata comprises one or more metadata payloads, wherein each metadata payload includes a plurality of sets of parameters and identifiers, with each set including a respective downmix identifier, downmixId, in combination with one or more processing parameters relating to the downmix identifier in the set, and wherein the one or more processing parameters are parameters for dynamic loudness adjustment by a decoder.

12. A system of an encoder (203) for encoding in a bitstream original audio data and metadata for dynamic loudness adjustment, according to claim 11 and a decoder (100) for metadata-based dynamic processing of audio data for playback according to claim 3.

13. A computer program product comprising a computer-readable storage medium with instructions adapted to cause the device to carry out the method according to any one of claims 1 to 2 or 4 to 10 when executed by a device having processing capability.

14. A computer-readable storage medium storing the computer program product of claim 13.

## Patentansprüche

1. Verfahren zur metadatenbasierten dynamischen Verarbeitung von Audiodaten zur Wiedergabe, wobei das Verfahren Folgendes beinhaltet:
Empfangen (S101), durch einen Decoder, eines Bitstroms, der Audiodaten und Metadaten zur dynamischen Lautstärkeanpassung beinhaltet, wobei die Metadaten zur dynamischen Lautstärkeanpassung eine Vielzahl von Sätzen von Metadaten umfassen, wobei jeder Satz von Metadaten einer jeweiligen Wiedergabebedingung entspricht;
Decodieren (S102), durch den Decoder, der Audiodaten und der Metadaten, um decodierte Audiodaten und die Metadaten zu erhalten;
Auswählen (S103), als Reaktion auf an den Decoder bereitgestellte Wiedergabebedingungsinformationen, eines Satzes von Metadaten, der einer bestimmten Wiedergabebedingung entspricht, und Extrahieren, aus dem ausgewählten Satz von Metadaten, eines oder mehrerer Verarbeitungsparameter zur dynamischen Lautstärkeanpassung;
Anwenden (S104) des extrahierten einen oder der mehreren Verarbeitungsparameter auf die decodierten Audiodaten, um verarbeitete Audiodaten zu erhalten;
Ausgeben (S105) der verarbeiteten Audiodaten zur Wiedergabe und
wobei der ausgewählte Satz von Metadaten einen Satz von Dynamikbereichskompression-, DRC, Sequenzen, DRCSet, beinhaltet,
wobei der Bitstrom ein MPEG-D DRC-Bitstrom ist und das Vorhandensein von Metadaten basierend auf einer MPEG-D DRC-Bitstromsyntax signalisiert wird, und
wobei die Metadaten eine oder mehrere Metadatennutzlasten umfassen, wobei jede Metadatennutzlast eine Vielzahl von Sätzen von Parametern und Kennungen beinhaltet, wobei jeder Satz eine jeweilige Downmix-Kennung, downmixld, in Kombination mit einem oder mehreren Verarbeitungsparametern beinhaltet, die sich auf die Downmix-Kennung in dem Satz beziehen.

2. Verfahren nach Anspruch 1, wobei ein loudnessInfoSetExtension()-Element verwendet wird, um die Metadaten als eine Nutzlast zu transportieren.

3. Decoder (100) zur metadatenbasierten dynamischen Verarbeitung von Audiodaten zur Wiedergabe, wobei der Decoder (100) einen oder mehrere Prozessoren und einen nichtflüchtigen Speicher umfasst, die dazu konfiguriert sind, ein Verfahren durchzuführen, das Folgendes beinhaltet:
Empfangen (S101), durch den Decoder (100), eines Bitstroms, der Audiodaten und Metadaten zur dynamischen Lautstärkeanpassung beinhaltet, wobei die Metadaten zur dynamischen Lautstärkeanpassung eine Vielzahl von Sätzen von Metadaten umfassen, wobei jeder Satz von Metadaten einer jeweiligen Wiedergabebedingung entspricht;
Decodieren (S102), durch den Decoder (100), der Audiodaten und der Metadaten, um decodierte Audiodaten und die Metadaten zu erhalten;
Auswählen (S103), als Reaktion auf eine an den Decoder bereitgestellte Wiedergabebedingung, eines Satzes von Metadaten, der einer bestimmten Wiedergabebedingung entspricht, und Extrahieren, aus dem ausgewählten Satz von Metadaten, eines oder mehrerer Verarbeitungsparameter zur dynamischen Lautstärkeanpassung;
Anwenden (S104) des extrahierten einen oder der mehreren Verarbeitungsparameter auf die decodierten Audiodaten, um verarbeitete Audiodaten zu erhalten;
Ausgeben (S105) der verarbeiteten Audiodaten zur Wiedergabe und
wobei der ausgewählte Satz von Metadaten einen Satz von Dynamikbereichskompression-, DRC, Sequenzen, DRCSet, beinhaltet,
wobei der Bitstrom ein MPEG-D DRC-Bitstrom ist und das Vorhandensein von Metadaten basierend auf einer MPEG-D DRC-Bitstromsyntax signalisiert wird, und
wobei die Metadaten eine oder mehrere Metadatennutzlasten umfassen, wobei jede Metadatennutzlast eine Vielzahl von Sätzen von Parametern und Kennungen beinhaltet, wobei jeder Satz eine jeweilige Downmix-Kennung, downmixld, in Kombination mit einem oder mehreren Verarbeitungsparametern beinhaltet, die sich auf die Downmix-Kennung in dem Satz beziehen.

4. Verfahren zum Codieren von Audiodaten und Metadaten zur dynamischen Lautstärkeanpassung in einen Bitstrom, wobei das Verfahren Folgendes beinhaltet:
Eingeben (S201) von ursprünglichen Audiodaten in einen Lautstärkenpegler zur Lautstärkeverarbeitung, um als eine Ausgabe vom Lautstärkenpegler lautstärkeverarbeitete Audiodaten zu erhalten;
Erzeugen (S202) der Metadaten zur dynamischen Lautstärkeanpassung basierend auf den lautstärkeverarbeiteten Audiodaten und den ursprünglichen Audiodaten; und
Codieren (S203) der ursprünglichen Audiodaten und der Metadaten in den Bitstrom,
wobei die Metadaten eine Vielzahl von Metadatensätzen umfassen, wobei jeder Metadatensatz einer jeweiligen Wiedergabebedingung entspricht,
wobei der Bitstrom ein MPEG-D DRC-Bitstrom ist und das Vorhandensein von Metadaten basierend auf einer MPEG-D DRC-Bitstromsyntax signalisiert wird, und
wobei die Metadaten eine oder mehrere Metadatennutzlasten umfassen, wobei jede Metadatennutzlast eine Vielzahl von Sätzen von Parametern und Kennungen beinhaltet, wobei jeder Satz eine jeweilige Downmix-Kennung, downmixld, in Kombination mit einem oder mehreren Verarbeitungsparametern beinhaltet, die sich auf die Downmix-Kennung in dem Satz beziehen, und wobei der eine oder die mehreren Verarbeitungsparameter Parameter zur dynamischen Lautstärkeanpassung durch einen Decoder sind.

5. Verfahren nach Anspruch 4, wobei das Verfahren weiter Erzeugen zusätzlicher Metadaten zur statischen Lautstärkeanpassung beinhaltet, die von einem Decoder verwendet werden sollen.

6. Verfahren nach Anspruch 4 oder 5, wobei das Erzeugen von Metadaten einen Vergleich der lautstärkeverarbeiteten Audiodaten mit den ursprünglichen Audiodaten beinhaltet und wobei die Metadaten basierend auf einem Ergebnis des Vergleichs erzeugt werden.

7. Verfahren nach Anspruch 6, wobei das Erzeugen von Metadaten weiter Messen der Lautstärke über einen oder mehrere vordefinierte Zeiträume beinhaltet, und wobei die Metadaten weiter basierend auf der gemessenen Lautstärke erzeugt werden.

8. Verfahren nach Anspruch 7, wobei das Messen ein Messen einer Gesamtlautstärke der Audiodaten umfasst.

9. Verfahren nach Anspruch 8, wobei das Messen ein Messen einer Lautstärke von Dialog in den Audiodaten umfasst.

10. Verfahren nach Anspruch 4, wobei ein loudnessInfoSetExtension()-Element verwendet wird, um die Metadaten als eine Nutzlast zu transportieren.

11. Encoder (203) zum Codieren von ursprünglichen Audiodaten und Metadaten zur dynamischen Lautstärkeanpassung in einem Bitstrom, wobei der Encoder (203) einen oder mehrere Prozessoren und einen nichtflüchtigen Speicher umfasst, die dazu konfiguriert sind, ein Verfahren durchzuführen, das Folgendes beinhaltet:
Eingeben von ursprünglichen Audiodaten in einen Lautstärkenpegler (201) zur Lautstärkeverarbeitung, um als eine Ausgabe vom Lautstärkenpegler (201) lautstärkeverarbeitete Audiodaten zu erhalten;
Erzeugen der Metadaten zur dynamischen Lautstärkeanpassung basierend auf den lautstärkeverarbeiteten Audiodaten und den ursprünglichen Audiodaten; und
Codieren der ursprünglichen Audiodaten und der Metadaten in den Bitstrom,
wobei die Metadaten eine Vielzahl von Metadatensätzen umfassen, wobei jeder Metadatensatz einer jeweiligen Wiedergabebedingung entspricht,
wobei der Bitstrom ein MPEG-D DRC-Bitstrom ist und das Vorhandensein von Metadaten basierend auf einer MPEG-D DRC-Bitstromsyntax signalisiert wird, und
wobei die Metadaten eine oder mehrere Metadatennutzlasten umfassen, wobei jede Metadatennutzlast eine Vielzahl von Sätzen von Parametern und Kennungen beinhaltet, wobei jeder Satz eine jeweilige Downmix-Kennung, downmixld, in Kombination mit einem oder mehreren Verarbeitungsparametern beinhaltet, die sich auf die Downmix-Kennung in dem Satz beziehen, und wobei der eine oder die mehreren Verarbeitungsparameter Parameter zur dynamischen Lautstärkeanpassung durch einen Decoder sind.

12. System aus einem Encoder (203) zum Codieren von ursprünglichen Audiodaten und Metadaten zur dynamischen Lautstärkeanpassung in einem Bitstrom nach Anspruch 11 und einem Decoder (100) zur metadatenbasierten dynamischen Verarbeitung von Audiodaten zur Wiedergabe nach Anspruch 3.

13. Computerprogrammprodukt, das ein computerlesbares Speichermedium mit Anweisungen umfasst, die dazu angepasst sind, die Vorrichtung zu veranlassen, das Verfahren nach einem der Ansprüche 1 bis 2 oder 4 bis 10 auszuführen, wenn sie von einer Vorrichtung ausgeführt werden, die Verarbeitungsfähigkeit aufweist.

14. Computerlesbares Speichermedium, das das Computerprogrammprodukt nach Anspruch 13 speichert.

## Revendications

1. Procédé de traitement dynamique basé sur des métadonnées de données audio pour la lecture, le procédé incluant :
la réception (S101), par un décodeur, d'un flux binaire incluant des données audio et des métadonnées pour l'ajustement de volume sonore dynamique, dans lequel les métadonnées pour l'ajustement de volume sonore dynamique comprennent une pluralité d'ensembles de métadonnées, dans lequel chaque ensemble de métadonnées correspond à une condition de lecture respective ;
le décodage (S102), par le décodeur, des données audio et des métadonnées pour obtenir des données audio décodées et les métadonnées ;
la sélection (S103), en réponse à des informations de condition de lecture fournies au décodeur, d'un ensemble de métadonnées correspondant à une condition de lecture spécifique, et l'extraction, à partir de l'ensemble de métadonnées sélectionné, d'un ou plusieurs paramètres de traitement pour l'ajustement de volume sonore dynamique ;
l'application (S104) de l'un ou de plusieurs paramètres de traitement extraits aux données audio décodées pour obtenir des données audio traitées ;
l'émission (S105) des données audio traitées pour la lecture, et
dans lequel l'ensemble sélectionné de métadonnées inclut un ensemble, DRCSet, de séquences de compression de plage dynamique, DRC,
dans lequel le flux binaire est un flux binaire MPEG-D DRC et la présence de métadonnées est signalée sur la base de la syntaxe de flux binaire MPEG-D DRC, et
dans lequel les métadonnées comprennent une ou plusieurs charges utiles de métadonnées, dans lequel chaque charge utile de métadonnées inclut une pluralité d'ensembles de paramètres et d'identifiants, chaque ensemble incluant un identifiant de sous-mixage respectif, downmixld, en combinaison avec un ou plusieurs paramètres de traitement relatifs à l'identifiant de sous-mixage dans l'ensemble.

2. Procédé selon la revendication 1, dans lequel un élément loudnessinfoSetExtension() est utilisé pour transporter les métadonnées en tant que charge utile.

3. Décodeur (100) pour le traitement dynamique basé sur des métadonnées de données audio pour la lecture, dans lequel le décodeur (100) comprend un ou plusieurs processeurs et une mémoire non transitoire configurés pour mettre en œuvre un procédé incluant :
la réception (S101), par le décodeur (100), d'un flux binaire incluant des données audio et des métadonnées pour l'ajustement de volume sonore dynamique, dans lequel les métadonnées pour l'ajustement de volume sonore dynamique comprennent une pluralité d'ensembles de métadonnées, dans lequel chaque ensemble de métadonnées correspond à une condition de lecture respective ;
le décodage (S102), par le décodeur (100), des données audio et des métadonnées pour obtenir des données audio décodées et les métadonnées ;
la sélection (S103), en réponse à une condition de lecture fournie au décodeur, d'un ensemble de métadonnées correspondant à une condition de lecture spécifique, et l'extraction, à partir de l'ensemble de métadonnées sélectionné, d'un ou plusieurs paramètres de traitement pour l'ajustement de volume sonore dynamique ;
l'application (S104) de l'un ou de plusieurs paramètres de traitement extraits aux données audio décodées pour obtenir des données audio traitées ;
l'émission (S105) des données audio traitées pour la lecture, et
dans lequel l'ensemble sélectionné de métadonnées inclut un ensemble, DRCSet, de séquences de compression de plage dynamique, DRC,
dans lequel le flux binaire est un flux binaire MPEG-D DRC et la présence de métadonnées est signalée sur la base de la syntaxe de flux binaire MPEG-D DRC, et
dans lequel les métadonnées comprennent une ou plusieurs charges utiles de métadonnées, dans lequel chaque charge utile de métadonnées inclut une pluralité d'ensembles de paramètres et d'identifiants, chaque ensemble incluant un identifiant de sous-mixage respectif, downmixld, en combinaison avec un ou plusieurs paramètres de traitement relatifs à l'identifiant de sous-mixage dans l'ensemble.

4. Procédé de codage de données audio et de métadonnées pour un ajustement dynamique du volume sonore dans un flux binaire, le procédé incluant :
l'entrée (S201) des données audio originales dans un niveleur de volume sonore pour un traitement de volume sonore pour obtenir, en tant que sortie du niveleur de volume sonore, des données audio traitées pour le volume sonore ;
la génération (S202) des métadonnées pour l'ajustement de volume sonore dynamique sur la base des données audio traitées pour le volume sonore et des données audio originales ; et
l'encodage (S203) des données audio originales et des métadonnées dans le flux binaire,
dans lequel les métadonnées comprennent une pluralité d'ensembles de métadonnées, dans lequel chaque ensemble de métadonnées correspond à une condition de lecture respective,
dans lequel le flux binaire est un flux binaire MPEG-D DRC et la présence de métadonnées est signalée sur la base de la syntaxe de flux binaire MPEG-D DRC, et
dans lequel les métadonnées comprennent une ou plusieurs charges utiles de métadonnées, dans lequel chaque charge utile de métadonnées inclut une pluralité d'ensembles de paramètres et d'identifiants, chaque ensemble incluant un identifiant de sous-mixage respectif, downmixld, en combinaison avec un ou plusieurs paramètres de traitement relatifs à l'identifiant de sous-mixage dans l'ensemble, et dans lequel l'un ou les plusieurs paramètres de traitement sont des paramètres pour l'ajustement de volume sonore dynamique par un décodeur.

5. Procédé selon la revendication 4, dans lequel le procédé inclut en outre la génération de métadonnées supplémentaires pour l'ajustement de volume sonore statique à utiliser par un décodeur.

6. Procédé selon la revendication 4 ou 5, dans lequel lesdites métadonnées de génération incluent la comparaison des données audio traitées pour le volume sonore avec les données audio originales, et dans lequel les métadonnées sont générées sur la base d'un résultat de ladite comparaison.

7. Procédé selon la revendication 6, dans lequel lesdites métadonnées de génération incluent en outre la mesure du volume sonore sur une ou plusieurs périodes de temps prédéfinies, et dans lequel les métadonnées sont générées en outre sur la base du volume sonore mesuré.

8. Procédé selon la revendication 7, dans lequel la mesure comprend la mesure du volume sonore global des données audio.

9. Procédé selon la revendication 8, dans lequel la mesure comprend la mesure du volume de dialogue dans les données audio.

10. Procédé selon la revendication 4, dans lequel un élément loudnessinfoSetExtension() est utilisé pour transporter les métadonnées en tant que charge utile.

11. Encodeur (203) pour encoder dans un flux binaire des données audio originales et des métadonnées pour l'ajustement de volume sonore dynamique, dans lequel l'encodeur (203) comprend un ou plusieurs processeurs et une mémoire non transitoire configurés pour mettre en œuvre un procédé incluant :
l'entrée des données audio originales dans un niveleur de volume sonore (201) pour un traitement de volume sonore pour obtenir, en tant que sortie du niveleur de volume sonore (201), des données audio traitées pour le volume sonore ;
la génération des métadonnées pour l'ajustement de volume sonore dynamique sur la base des données audio traitées pour le volume sonore et des données audio originales ; et
l'encodage des données audio originales et des métadonnées dans le flux binaire,
dans lequel les métadonnées comprennent une pluralité d'ensembles de métadonnées, dans lequel chaque ensemble de métadonnées correspond à une condition de lecture respective,
dans lequel le flux binaire est un flux binaire MPEG-D DRC et la présence de métadonnées est signalée sur la base de la syntaxe de flux binaire MPEG-D DRC, et
dans lequel les métadonnées comprennent une ou plusieurs charges utiles de métadonnées, dans lequel chaque charge utile de métadonnées inclut une pluralité d'ensembles de paramètres et d'identifiants, chaque ensemble incluant un identifiant de sous-mixage respectif, downmixId, en combinaison avec un ou plusieurs paramètres de traitement relatifs à l'identifiant de sous-mixage dans l'ensemble, et dans lequel l'un ou les plusieurs paramètres de traitement sont des paramètres pour l'ajustement de volume sonore dynamique par un décodeur.

12. Système d'un encodeur (203) pour encoder dans un flux binaire des données audio originales et des métadonnées pour l'ajustement de volume sonore dynamique selon la revendication 11 et un décodeur (100) pour le traitement dynamique basé sur des métadonnées de données audio pour la lecture selon la revendication 3.

13. Produit de programme informatique comprenant un support de stockage lisible par ordinateur avec des instructions adaptées pour amener le dispositif à mettre en œuvre le procédé selon l'une quelconque des revendications 1 à 2 ou 4 à 10 lorsqu'elles sont exécutées par le dispositif présentant une capacité de traitement.

14. Support de stockage lisible par ordinateur stockant le programme informatique selon la revendication 13.
